(19) Europäisches Patentamt
European Patent Office
Office européen des brevets

(11) **EP 4 779 869 A1**

(12) **EUROPEAN PATENT APPLICATION**
published in accordance with Art. 153(4) EPC

(43) Date of publication:
**22.07.2026   Bulletin 2026/30**

(21) Application number: **24865132.5**

(22) Date of filing: **07.08.2024**

(51) International Patent Classification (IPC):
**H03K 3/354** (2006.01)      **H03K 19/003** (2006.01)

(52) Cooperative Patent Classification (CPC):
**H03K 3/354; H03K 19/003**

(86) International application number:
**PCT/JP2024/028309**

(87) International publication number:
**WO 2025/057626 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:   **13.09.2023   JP 2023148596**

(71) Applicant: **Sony Semiconductor Solutions Corporation**
**Atsugi-shi, Kanagawa 243-0014 (JP)**

(72) Inventors:
• **KIKUCHI, Hidekazu**
  **Atsugi-shi, Kanagawa 243-0014 (JP)**
• **TANAKA, Tomokazu**
  **Atsugi-shi, Kanagawa 243-0014 (JP)**
• **MOROHASHI, Hideo**
  **Atsugi-shi, Kanagawa 243-0014 (JP)**
• **HARA, Shintaro**
  **Atsugi-shi, Kanagawa 243-0014 (JP)**
• **GOSHO, Kunio**
  **Atsugi-shi, Kanagawa 243-0014 (JP)**

(74) Representative: **MFG Patentanwälte**
**Meyer-Wildhagen Meggle-Freund**
**Gerhard PartG mbB**
**Amalienstraße 62**
**80799 München (DE)**

(54) **CIRCUIT DEVICE, SEMICONDUCTOR INTEGRATED CIRCUIT, CAMERA, AND MOBILE BODY DEVICE**

(57)   To provide a circuit device capable of stabilizing an oscillation frequency of a ring oscillator at any frequency.

A circuit device according to the present technology includes: a ring oscillator including a plurality of inverters connected in a ring shape; and a drive circuit configured to drive the ring oscillator, in which the drive circuit is configured to suppress a change in oscillation frequency of the ring oscillator due to a temperature change. According to the circuit device according to the present technology, it is possible to provide a circuit device capable of stabilizing an oscillation frequency of a ring oscillator at any frequency.

FIG. 5

**Description**

TECHNICAL FIELD

The technology according to the present disclosure (hereinafter also referred to as "the present technology") relates to a circuit device, a semiconductor integrated circuit, a camera, and a mobile object device.

BACKGROUND ART

Conventionally, a circuit device including a ring oscillator including a plurality of inverters connected in a ring shape is known (see Patent Document 1 to 3).

CITATION LIST

PATENT DOCUMENT

Patent Document 1: Japanese Patent Application Laid-Open No. H03-252216
Patent Document 2: Japanese Patent Application Laid-Open No. 2004-080550
Patent Document 3: Japanese Patent Application Laid-Open No. 2001-068976

SUMMARY OF THE INVENTION

PROBLEMS TO BE SOLVED BY THE INVENTION

In the conventional circuit device, there has been room for improvement in stabilizing an oscillation frequency of the ring oscillator at any frequency.

Therefore, a main object of the present technology is to provide a circuit device capable of stabilizing an oscillation frequency of a ring oscillator at any frequency.

SOLUTIONS TO PROBLEMS

The present technology provides a circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

The drive circuit may include a negative feedback control unit configured to perform negative feedback control of a power supply current on the basis of a power supply voltage of the ring oscillator, in which the power supply voltage is generated when at least a part of the power supply current is supplied to the ring oscillator.

Substantially all of the power supply current may be supplied to the ring oscillator, and a ratio between the power supply voltage and the power supply current may be substantially constant.

The negative feedback control unit may include a reference resistor configured to define the ratio, and a temperature coefficient of a resistance value of the reference resistor may be set to a predetermined value or less.

The ring oscillator may have a load capacitor connected to the inverter, and a temperature coefficient of a capacitance value of the load capacitor may be set to a predetermined value or less.

The negative feedback control unit may include a reference resistor configured to define the ratio, and a resistance value of the reference resistor may be set according to a target set value of the oscillation frequency.

The resistance value may be set lower as the target set value is higher.

The drive circuit may include a voltage follower and a buffer circuit, substantially all of the power supply current may be supplied to the ring oscillator, the power supply voltage may be supplied to the voltage follower, and the power supply voltage reproduced by the voltage follower may serve as a power supply of the buffer circuit.

The drive circuit may include a level shifter configured to convert an output signal of the buffer circuit into a toggle signal that reciprocates between a reference potential and a power supply potential.

The drive circuit may include a startup circuit for avoidance of a zero point of the negative feedback control.

The drive circuit may include a masking circuit configured to mask an output signal of the ring oscillator immediately after activation.

The negative feedback control unit may perform negative feedback control on the at least a part of the power supply current to be proportional to a voltage having a negative temperature characteristic.

The negative feedback control unit may include: a current source capable of adjusting a temperature coefficient of the voltage; and a resistor having a negative temperature characteristic and connected to the current source, and the negative feedback control unit may generate the voltage by using the current source and the resistor.

The negative feedback control unit may include a reference resistor configured to define a ratio between the voltage and the power supply current and having a variable resistance value.

The drive circuit may include a masking circuit configured to mask an output signal of the ring oscillator immediately after activation.

The present technology also provides a semiconductor integrated circuit including a circuit device, in which

the circuit device can serve as a clock oscillation source,
the circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

The semiconductor integrated circuit may further include a crystal oscillator that can serve as a clock oscillation source, in which the oscillation source can be switched between the circuit device and the crystal oscillator.

The present technology also provides a camera including:

a circuit device; and
a solid-state imaging device in which the circuit device serves as a clock oscillation source,
the circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

The camera may output a clock from the circuit device to an external device via a serial transmission path.

The present technology also provides a mobile object device including:

a camera; and
a mobile object on which the camera is mounted,
the camera including:

a circuit device; and
a solid-state imaging device in which the circuit device serves as a clock oscillation source,
the circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

BRIEF DESCRIPTION OF DRAWINGS

Fig. 1 is a circuit diagram illustrating a configuration example of a circuit device of a comparative example.
Figs. 2A and 2B are diagrams for explaining operations of load charging and load discharging in the circuit device of Fig. 1, respectively.
Fig. 3 is a timing chart illustrating timings of load charging and load discharging of the circuit device of Fig. 1.

Fig. 4 is a graph illustrating a relationship between a current-voltage characteristic of an inverter ring of the circuit device of Fig. 1 and a target set value of an oscillation frequency.

Fig. 5 is a circuit diagram illustrating a configuration of a circuit device according to Example 1 of a first embodiment of the present technology.

Fig. 6A is a diagram illustrating Configuration example 1 of an inverter ring of the circuit device of Fig. 5. Fig. 6B is a diagram illustrating Configuration example 2 of the inverter ring of the circuit device of Fig. 5.

Fig. 7 is a circuit diagram illustrating a configuration of a circuit device according to Example 2 of the first embodiment of the present technology.

Fig. 8 is a circuit diagram illustrating a configuration of a circuit device according to Example 3 of the first embodiment of the present technology.

Fig. 9 is a diagram illustrating a configuration example of a reference resistor of the circuit device of Fig. 8.

Fig. 10A is a graph illustrating a relationship between a binary value of a frequency trim bus and a reciprocal of a combined resistance in the reference resistor of Fig. 9. Fig. 10B is a graph illustrating a relationship between a current-voltage characteristic of an inverter ring of the circuit device of Fig. 8 and a target set value of an oscillation frequency.

Fig. 11 is a circuit diagram illustrating a configuration of a circuit device according to Example 4 of the first embodiment of the present technology.

Fig. 12A is a graph illustrating a current-voltage characteristic of an inverter ring of the circuit device of Fig. 11. Fig. 12B is a graph illustrating a relationship between a current of the inverter ring of the circuit device in Fig. 11 and a residual voltage in a negative feedback control unit.

Fig. 13 is a diagram illustrating a configuration example of a voltage follower of the circuit device of Fig. 8.

Figs. 14A and 14B are diagrams illustrating Configuration examples 1 and 2 of a level shifter of the circuit device of Fig. 8, respectively.

Figs. 15A and 15B are diagrams illustrating Configuration examples 3 and 4 of the level shifter of the circuit device of Fig. 8, respectively.

Fig. 16 is a circuit diagram illustrating a configuration of a circuit device according to Example 5 of the first embodiment of the present technology.

Fig. 17 is a timing chart illustrating a voltage change at a time of activation of the circuit device of Fig. 16.

Fig. 18 is a timing chart illustrating an input signal to a D latch, an output signal from the D latch, and an output signal of an AND gate.

Fig. 19 is a circuit diagram illustrating a configuration of a circuit device according to Example 1 of a second embodiment of the present technology.

Fig. 20A is a graph illustrating a relationship between a current-voltage characteristic of an inverter ring of the circuit device of Fig. 19 and a target set value of an oscillation frequency. Fig. 20B is a graph illustrating temperature dependency of a power supply current at an operating point of the inverter ring oscillating at the same frequency.

Fig. 21 is a diagram illustrating Configuration example 1 of the inverter ring of the circuit device of Fig. 19.

Fig. 22 is a diagram illustrating Configuration example 2 of the inverter ring of the circuit device of Fig. 19.

Fig. 23 is a diagram illustrating Configuration example 3 of the inverter ring of the circuit device of Fig. 19.

Fig. 24 is a diagram illustrating a configuration example of a temperature coefficient adjustment current source of the circuit device of Fig. 19.

Figs. 25A to 25D are diagrams illustrating Configuration examples 1 to 4 of a negative temperature characteristic resistance load of the circuit device of Fig. 19, respectively.

Fig. 26 is a diagram illustrating Configuration example 5 of the negative temperature characteristic resistance load of the circuit device of Fig. 19.

Fig. 27 is a circuit diagram illustrating a configuration of a circuit device according to Example 2 of a second embodiment of the present technology.

Fig. 28 is a circuit block diagram illustrating a configuration example of a semiconductor integrated circuit according to a third embodiment of the present technology.

Fig. 29 is a circuit block diagram illustrating a configuration example of a camera monitoring system according to a fourth embodiment of the present technology.

Fig. 30 is a diagram illustrating a configuration example of a mobile object device according to a fifth embodiment of the present technology.

Fig. 31 is a circuit diagram illustrating a configuration of a circuit device according to Modification 1 of the second embodiment of the present technology.

Fig. 32 is a circuit diagram illustrating a configuration of a circuit device according to Modification 2 of the second embodiment of the present technology.

Fig. 33 is a circuit diagram illustrating a configuration of a circuit device according to Modification 3 of the second embodiment of the present technology.

## MODE FOR CARRYING OUT THE INVENTION

Hereinafter, preferred embodiments of the present technology will be described in detail with reference to the accompanying drawings. Note that, in the present specification and the drawings, components having substantially the same functional configuration are denoted by the same reference numerals, and redundant explanations are omitted. The embodiments to be described below provide representative embodiments of the present technology, and the scope of the present technology is not to be narrowly interpreted according to those embodiments. In the present specification, even in a case where it is described that a circuit device, a semiconductor integrated circuit, a camera, and a mobile object device according to the present technology exhibit a plurality of effects, it suffices that the circuit device, the semiconductor integrated circuit, the camera, and the mobile object device according to the present technology exhibit at least one effect. The effects described in the present specification are merely examples and are not limited, and other effects may also be present.

Furthermore, the description will be given in the following order.

0. Introduction
1. Circuit device according to first embodiment of present technology
2. Circuit device according to second embodiment of present technology
3. Semiconductor integrated circuit according to third embodiment of present technology
4. Camera monitoring system according to fourth embodiment of present technology
5. Mobile object device according to fifth embodiment of present technology
6. Modification of present technology

<<0. Introduction>>

An inverter ring (ring oscillator) in which inverters (for example, CMOS inverters) are connected in a plurality of stages in a ring shape is a low-power oscillation circuit that is easily integrated as a semiconductor circuit and has high reliability. However, the inverter ring has a feature that an oscillation frequency greatly fluctuates according to a power supply voltage, manufacturing variations of a MOS threshold, and an operating temperature.

In order for the inverter ring to be used as a clock oscillation source of a logic circuit, a switched capacitor filter (SCF) circuit, or a transmission circuit by generating a clock with a semiconductor circuit alone without having a clock supply from an outside or a connection with an off-chip quartz crystal or the like, it is desirable that an oscillation frequency after manufacturing for compensating for manufacturing variations of a MOS threshold can be adjusted and set, and the adjusted and set oscillation frequency be constant regardless of an operating temperature and a power supply voltage to be supplied to the semiconductor circuit. For this reason, conventionally, as a clock oscillation source, it has been difficult to use an inverter ring having high temperature dependency of an oscillation frequency.

Therefore, after intensive studies, the inventors have succeeded in developing a circuit technology for reducing the temperature dependency of an oscillation frequency of the ring oscillator (inverter ring). Then, the inventors have developed a circuit device according to the present technology as a circuit device embodying this circuit technology. According to the circuit device according to the present technology, an oscillation frequency of a ring oscillator can be stabilized at any frequency. Furthermore, the inventors have also developed a semiconductor integrated circuit, a camera, and a mobile object device including the circuit device according to the present technology.

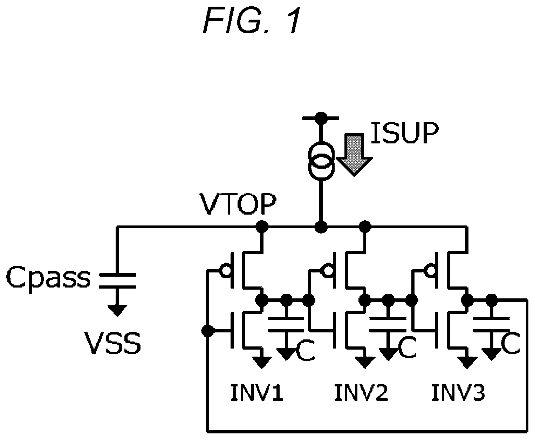

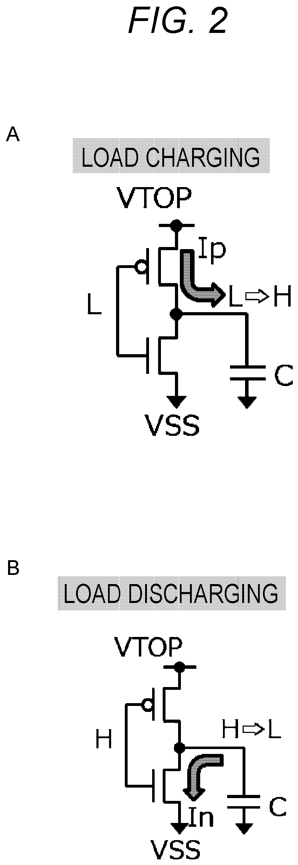

Fig. 1 is a circuit diagram illustrating a circuit device (oscillator) of a comparative example serving as a base of the circuit device (oscillator) of the present technology. An oscillation frequency of an inverter ring (ring oscillator) is proportional to a ratio between a power supply current ISUP supplied to the inverter ring and a power supply voltage VTOP of the inverter ring at the time of ISUP supply. This will be described in a state where the current ISUP is supplied to a power supply of a three-stage inverter ring including inverters INV1 to INV3 in Fig. 1, and the voltage VTOP is generated. In Fig. 1, C is a load capacitor of each inverter, and Cpass is a power supply smoothing capacitor. The power supply current ISUP is a direct current, and the power supply voltage VTOP is also substantially a direct current due to an effect of the power supply smoothing capacitor Cpass. Fig. 2A illustrates a state in which an input is fixed at approximately a VSS level, that is, low, at any of INV1 to INV3, and a current Ip through a PMOS is charging the output load capacitor C. Fig. 2B illustrates a state in which an input is fixed at approximately a VTOP level, that is, high, at any of INV1 to INV3, and a current In through an NMOS is discharging the output load capacitor C.

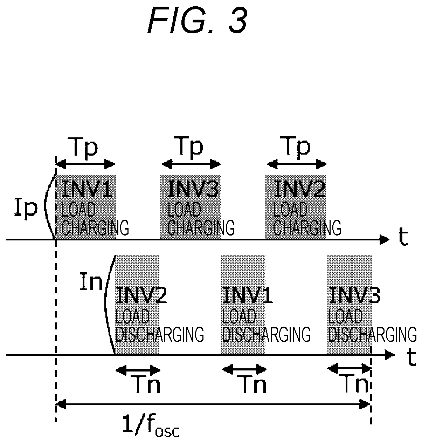

When there is no overlap or gap between a charging period and a discharging period, and Ip and In are each approximated as constant values, the charging/discharging state occurring in the three inverters INV1 to INV3 becomes a cycle of six states illustrated in Fig. 3. The circulation period is an oscillation period, and reciprocal of the oscillation period is an oscillation frequency fosc.

When a pulse width of the PMOS current Ip is Tp and a pulse width of the NMOS current In is Tn, the following Equations (1) and (2) are satisfied from a relationship between a current and a charge. Here, VSS is a reference potential (negative power supply), and is, for example, 0 V.

$$Tp \times Ip = C \times VTOP \quad \cdots(1)$$

$$Tn \times In = C \times VTOP \quad \cdots(2)$$

Since the power supply current ISUP becomes an average of a PMOS pulsating flow due to the power supply smoothing capacitor Cpass, the following Equation (3) is satisfied.

$$\begin{aligned} ISUP &= Ip \times Tp/(Tp + Tn) \\ &= Ip \times (C \times VTOP/Ip)/(Tp + Tn) \\ &= C \times VTOP/(Tp + Tn) \quad \cdots(3) \end{aligned}$$

From Equation (3) above, the following Equation (4) is obtained.

$$Tp + Tn = C \times VTOP/ISUP \quad \cdots(4)$$

Since the oscillation cycle is $3 \times (Tp + Tn)$, the oscillation frequency fosc is expressed by the following Equation (5).

$$\begin{aligned} fosc &= 1/(3 \times (Tp + Tn)) \\ &= 1/(3 \times C \times VTOP/ISUP) \\ &= (ISUP/VTOP)/(3 \times C) \quad \cdots(5) \end{aligned}$$

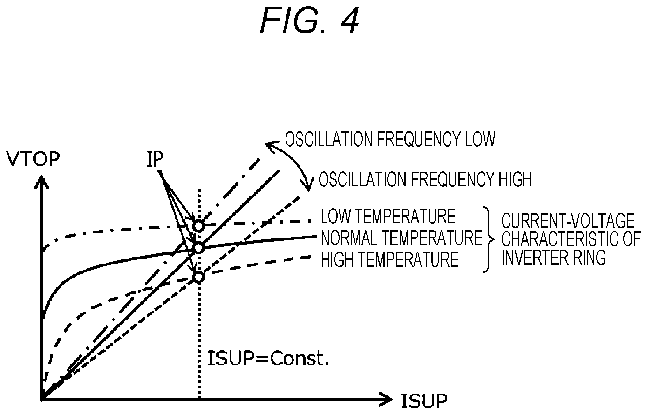

That is, the oscillation frequency fosc is proportional to ISUP/VTOP. As can be seen from the fact that In is Id (drain current) of the NMOS with VTOP applied to a gate, the relationship between ISUP and VTOP is similar to a relationship between Id (drain current) and Vgs (gate voltage) of the MOS transistor. A typical relationship between ISUP and VTOP at three temperatures of high temperature, normal temperature, and low temperature is a parabola group as illustrated in Fig. 4. Assuming that the power supply current ISUP supplied to the inverter ring is a constant current independent of temperature, a state of the inverter ring is an intersection point IP between each parabola and a perpendicular line indicating that ISUP is constant (Const). Since the intersection points IP each have the same ISUP and different VTOPs, slopes ISUP/VTOP of the straight lines passing through an origin (ISUP = 0, VTOP = 0) and the individual intersection points IP are different from each other. This indicates that the oscillation frequency when the inverter ring is driven with a constant current without temperature dependency changes according to the temperature. Similarly, even when the inverter ring is driven with a constant voltage without temperature dependency, the oscillation frequency changes according to the temperature.

As described in detail in the following first and second embodiments, the circuit device according to the present technology is obtained by greatly improving the circuit device of the above-described comparative example, and it is possible to reduce the temperature dependency of the oscillation frequency of the inverter ring. In the following description, a voltage may be used to denote a terminal or a node in a circuit diagram for convenience.

<<1. Circuit device according to first embodiment of present technology>>

Hereinafter, a circuit device according to a first embodiment of the present technology will be described in detail with some examples.

(Example 1)

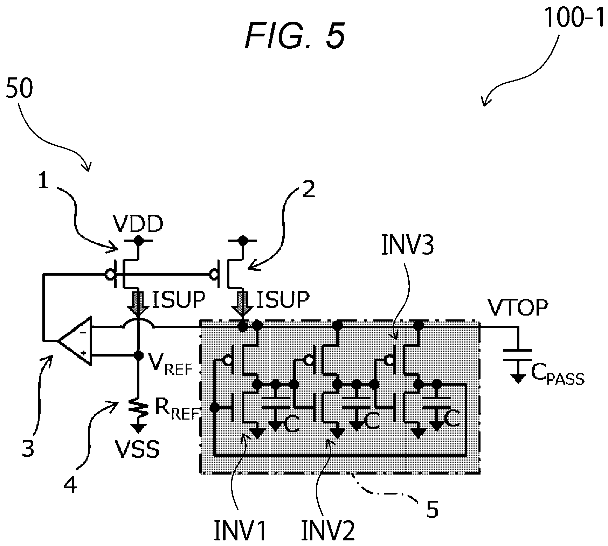

Fig. 5 is a circuit diagram illustrating a configuration of a circuit device 100-1 (oscillator) according to Example 1 of the first embodiment of the present technology. As an example, the circuit device 100-1 can be used as an oscillator (clock oscillation source) of a clock signal transmitted to and used by various blocks in a semiconductor integrated circuit.

The circuit device 100-1 includes an inverter ring 5 (ring oscillator) including a plurality of (for example, three) inverters INV (for example, INV1, INV2, and INV3) connected in a ring shape, and a drive circuit 50 configured to drive the inverter ring 5. The inverter ring 5 further includes a load capacitor C connected to each inverter INV.

Each inverter INV has a CMOS transistor including a PMOS transistor and an NMOS transistor.

The drive circuit 50 is configured to suppress a change in oscillation frequency of the inverter ring 5 due to a temperature change.

The drive circuit 50 includes a negative feedback control unit configured to perform negative feedback control of a power supply current ISUP on the basis of a power supply voltage VTOP of the inverter ring 5 generated by supplying at least a part of the power supply current ISUP to the inverter ring 5.

Here, substantially all (for example, 99.5% or more) of the power supply current ISUP is supplied to the inverter ring 5, and a ratio between the power supply voltage VTOP and the power supply current ISUP is substantially constant (ISUP/VTOP can fluctuate within a range of $\pm$ 0.5%).

As an example, the negative feedback control unit includes PMOS transistors 1 and 2, an operational amplifier 3, and a reference resistor 4.

In the PMOS transistors 1 and 2, each source is connected to a power supply potential VDD (positive power supply), and each gate is connected in common to an output of the operational amplifier 3. Drain currents of the PMOS transistors 1 and 2 are always equal. A current value of the drain current is the power supply current ISUP. A drain of the PMOS transistor 1 is connected to one end of the reference resistor 4. Another end of the reference resistor 4 is connected to a reference potential VSS (negative power supply). That is, the drain of the PMOS transistor 1 uses the reference resistor 4 as a load. A drain of the PMOS transistor 2 is connected to a source of a PMOS transistor of each inverter INV. That is, the drain of the PMOS transistor 2 uses the inverter ring 5 as a load, and a potential of the drain is the power supply voltage VTOP. VTOP is an inverting input of the operational amplifier 3.

The reference resistor 4 determines a ratio between the power supply voltage VTOP and the power supply current ISUP. A voltage across the reference resistor 4 is $V_{REF}$. $V_{REF}$ is a non-inverting input of the operational amplifier 3.

Due to a very high gain of the operational amplifier 3 and the effect of negative feedback, the inverting input and the non-inverting input of the operational amplifier 3 converge to a state called a virtual short in which there is almost no potential difference. That is, VTOP = $V_{REF}$.

The following Equation (6) is satisfied between ISUP and $V_{REF}$ by Ohm's law with a resistance value of the reference resistor 4 as $R_{REF}$.

$$\text{ISUP}/V_{REF} = 1/R_{REF} \quad \cdots (6)$$

From Equation (6) above and VTOP = $V_{REF}$, the following Equation (7) is obtained.

$$\text{ISUP}/\text{VTOP} = 1/R_{REF} \quad \cdots (7)$$

When Equation (7) above is substituted into Equation (5) above, the following Equation (8) is obtained.

$$\text{fosc} = 1/(3 \times C \times R_{REF}) \quad \cdots (8)$$

<Load capacitor>

Meanwhile, a temperature coefficient of a capacitance between metal wires and the like in the semiconductor integrated circuit is very small. Therefore, if a ratio of the capacitance between metal wires and the like in the load capacitor C connected to the inverter INV is sufficiently large, a temperature coefficient of a capacitance value of the load capacitor C can be made sufficiently small. According to Equation (8) above, a temperature characteristic (temperature dependency) of the oscillation frequency fosc can be made smaller as the temperature coefficient of the load capacitor C is smaller.

Therefore, as an example, the temperature coefficient of the capacitance value of the load capacitor C is preferably set to a predetermined value or less. The predetermined value is preferably 6% or less, more preferably 5% or less, more preferably 4% or less, and more preferably 3% or less within an operating temperature range. The predetermined value may be 2% or more, 3% or more, 4% or more, or 5% or more within the operating temperature range.

<Reference resistor>

Furthermore, as a resistor, polysilicon doped with an appropriate amount of impurities has a small temperature coefficient, and a temperature characteristic (temperature dependency) of $R_{REF}$ can be reduced by using the polysilicon as a material of the reference resistor 4. Furthermore, by connecting a resistor having a resistance value of a positive temperature characteristic and a resistor having a negative temperature characteristic in series or in parallel, the resistor $R_{REF}$ having a small temperature characteristic can also be synthesized. From Equation (7) above, decreasing the temperature characteristic of $R_{REF}$ leads to decreasing the temperature characteristic of ISUP/VTOP. Moreover, from Equation (8) above, decreasing the temperature characteristic of $R_{REF}$ leads to decreasing the temperature characteristic (temperature dependency) of the oscillation frequency fosc.

Therefore, in the reference resistor 4, for example, the temperature coefficient of the resistance value $R_{REF}$ is preferably set to a predetermined value or less. The predetermined value is preferably 6% or less, more preferably 5% or less, more preferably 4% or less, and more preferably 3% or less within an operating temperature range. The predetermined value may be 2% or more, 3% or more, 4% or more, or 5% or more within the operating temperature range.

As described above, it is possible to set the temperature characteristic, which depends on C and $R_{REF}$, on the right side of Equation (8) above to be extremely small, and it is possible to set the oscillation frequency fosc to a substantially constant value that hardly depends on the temperature or completely does not depend on the temperature.

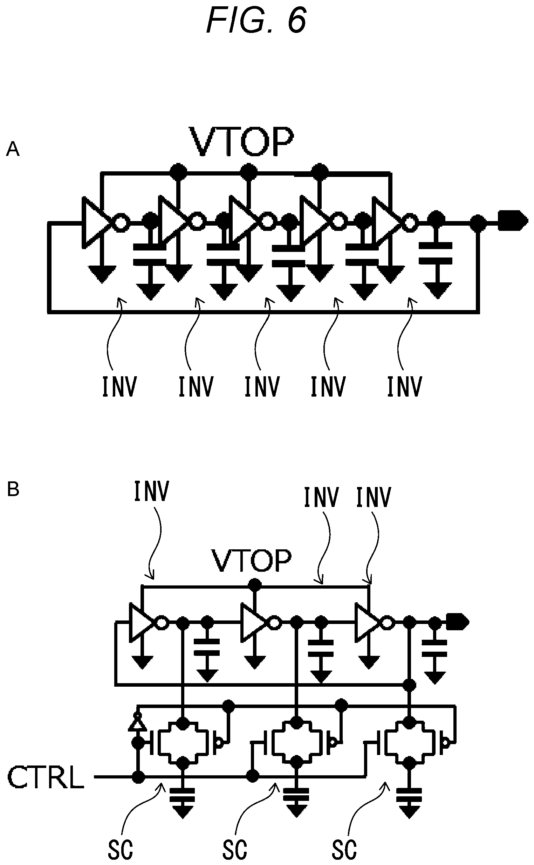

Here, the inverter ring 5 has a three-stage configuration including three inverters INV, but may have a five-stage configuration including five inverters INV illustrated in Fig. 6A. The inverter ring 5 can have an odd number stage configuration including any odd number of inverters INV. Furthermore, without limiting to the constant load capacitor C, the inverter ring 5 may include a switched capacitor SC in which a capacitance value can be selected, for example, as illustrated in Fig. 6B.

(Example 2)

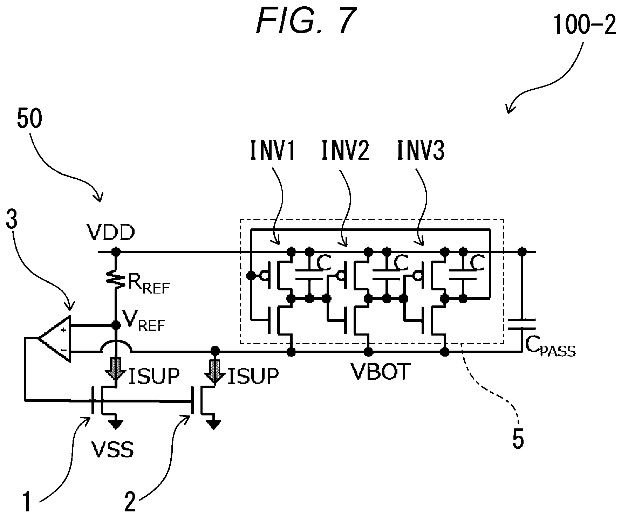

Fig. 7 is a circuit diagram illustrating a configuration of a circuit device 100-2 according to Example 2 of the first embodiment of the present technology. In the circuit device 100-2, as illustrated in Fig. 7, a power supply (a potential on the PMOS transistor side of each inverter INV) of the inverter ring 5 is fixed to the power supply potential VDD (positive power supply), and the current ISUP is pulled out from VSS (a potential on the NMOS transistor side of each inverter INV). A principle that the temperature dependency of the oscillation frequency of the inverter ring 5 is low is the same as that of Example 1.

(Example 3)

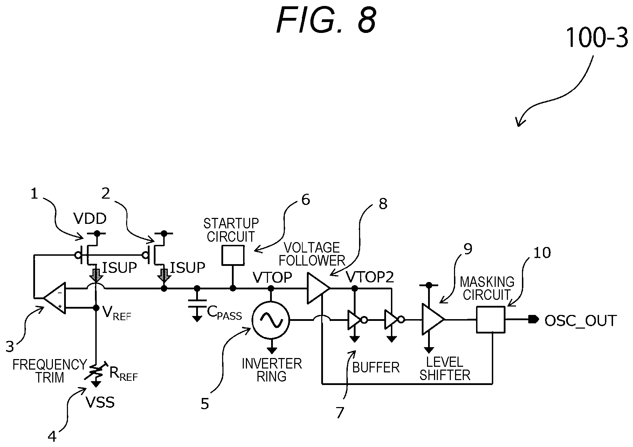

Fig. 8 is a circuit diagram illustrating a configuration of a circuit device 100-3 according to Example 3 of the first embodiment of the present technology. The circuit device 100-3 is a more practical circuit in which various functions are added to the circuit device 100-1 according to Example 1.

As illustrated in Fig. 8, the circuit device 100-3 further includes a startup circuit 6, a buffer 7 (buffer circuit), a voltage follower 8, a level shifter 9, and a masking circuit 10.

In the circuit device 100-3, substantially all (for example, 99.5% or more) of the power supply current ISUP is supplied to the inverter ring 5, and the power supply voltage VTOP generated in the inverter ring 5 is supplied to the voltage follower 8. The startup circuit 6 avoids a zero point of the negative feedback control. More specifically, the startup circuit 6 monitors the power supply voltage VTOP of the inverter ring 5 to avoid malfunction of a negative feedback loop (NFBL). The voltage follower 8 supplies power to the buffer 7. A power supply voltage VTOP2 reproduced by the voltage follower 8 serves as a power supply of the buffer 7. The buffer 7 extracts an output signal from the inverter ring 5. The level shifter 9 converts the output of the buffer 7 into a CMOS logic level, and outputs the converted output to the masking circuit 10. The masking circuit 10 masks the output signal of the inverter ring 5 immediately after activation.

<Reference resistor having stepwise adjustment function>

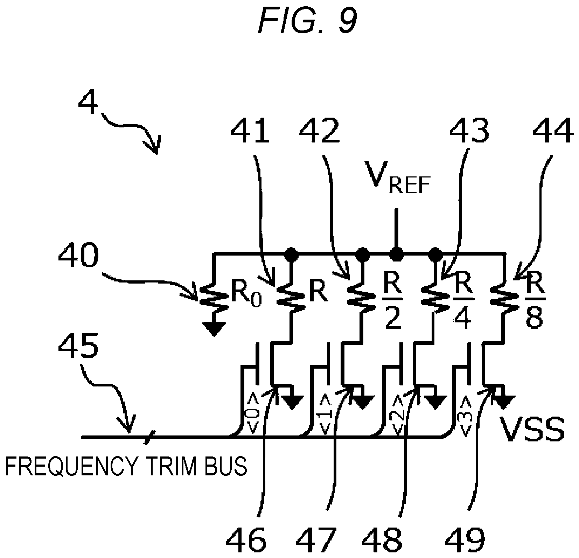

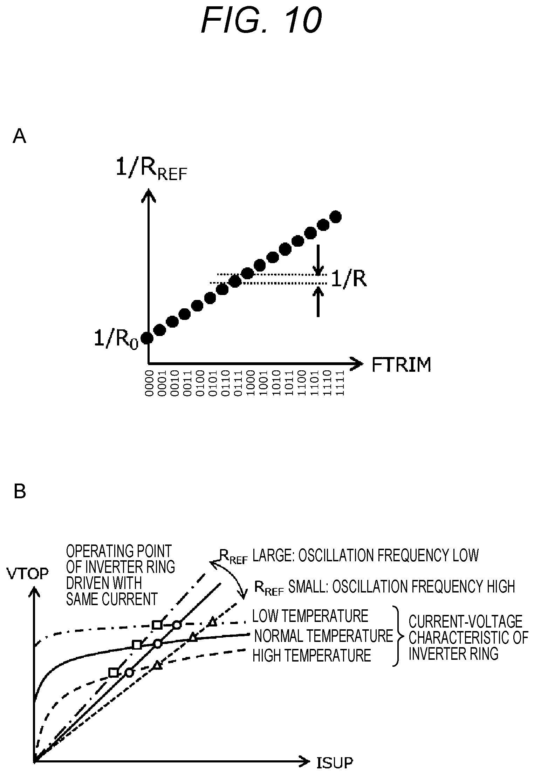

Fig. 9 is a diagram illustrating a configuration example of the reference resistor 4 of the circuit device 100-3 of Fig. 8. Fig. 10A is a graph illustrating a relationship between a binary value of a frequency trim bus 45 and a reciprocal of a combined resistance $R_{REF}$ in the inverter ring 5 of Fig. 9. Fig. 10B is a graph illustrating a relationship between a current-voltage characteristic of the inverter ring 5 of the circuit device 100-3 of Fig. 8 and a target set value of the oscillation frequency fosc.

In the circuit device 100-3, the reference resistor 4 has a stepwise adjustment function. The reference resistor 4 having the stepwise adjustment function is configured as illustrated in Fig. 9, for example. This reference resistor 4 is a combined resistor circuit between $V_{REF}$ and VSS, and includes a fixed resistor 40, parallel resistors 41 to 44, and NMOS switches 46 to 49 opened and closed by the four-bit frequency trim bus 45. As an example, each of the parallel resistors 41 to 44 has one end connected to one another and another end connected to a drain of a corresponding NMOS switches 46 to 49. The fixed resistor 40 has one end connected to the parallel resistors 41 to 44 and another end grounded.

In a case where resistance values of the parallel resistors 41 to 44 are in a multiple series as illustrated in Fig. 9 and ON resistance of the NMOS switches 46 to 49 is negligibly small with respect to the resistance values of the parallel resistors 41 to 44, the combined resistance $R_{REF}$ of the reference resistor 4 is adjusted by the frequency trim bus 45 as illustrated in Fig. 10A. In Fig. 10A, a horizontal axis represents a value of the frequency trim bus 45 arranged in binary, and a vertical axis represents a reciprocal of $R_{REF}$. When the values of the frequency trim bus 45 are all 0, the NMOS switches 46 to 49 are all OFF, and the combined resistance value $R_{REF}$ is equal to a resistance value R0 of the fixed resistor 40. When at least one bit of the frequency trim bus 45 becomes 1, at least one NMOS switch opened with the bit is conducted, at least one parallel resistor connected to the at least one NMOS switch is in parallel with the fixed resistor 40, and a reciprocal $1/R_{REF}$ of the combined resistance is increased. The reciprocal $1/R_{REF}$ of the combined resistance changes linearly with respect to the binary value of the frequency trim bus 45.

Fig. 10B illustrates an operating point of the inverter ring 5 when a resistance value (combined resistance $R_{REF}$) of the reference resistor 4 is adjusted. Three square marks on an alternate long and short dash line passing through the origin are operating points at high temperature, normal temperature, and low temperature in a case where $R_{REF}$ is large. As indicated by Equation (8) above, the oscillation frequencies of the inverter ring 5 at these operating points are the same. Three triangle marks on a broken line passing through the origin are operating points at high temperature, normal temperature, and low temperature in a case where $R_{REF}$ is small. The oscillation frequencies of the inverter ring 5 at these operating points are the same, but are higher than the oscillation frequencies in the case where $R_{REF}$ is large. Three circles on a solid line passing through the origin are operating points at high temperature, normal temperature, and low temperature in a case where $R_{REF}$ is in midrange. The oscillation frequencies of the inverter ring 5 at these operating points are the same, but are higher than the oscillation frequencies in the case where $R_{REF}$ is large and are lower than the oscillation frequencies in the case where $R_{REF}$ is small.

As described above, the oscillation frequency of the inverter ring 5 can be adjusted even after manufacturing of the circuit device 100-3 by controlling the frequency trim bus 45 with an I2C register or the like to adjust the resistance value of the reference resistor 4, and the adjusted oscillation frequency becomes a stable frequency with low temperature dependency.

In the circuit device 100-3, the resistance value of the reference resistor 4 is set according to a target set value (specification value) of the oscillation frequency fosc of the inverter ring 5. In this case, the resistance value of the reference resistor 4 is preferably set lower as the target set value is higher. As a result, the oscillation frequency fosc can be set to the target set value, and the set oscillation frequency fosc becomes a stable frequency having low temperature dependency. The resistance value of the reference resistor 4 is set at the time of manufacturing the circuit device 100-3, but may be reset (adjusted) after manufacturing.

(Example 4)

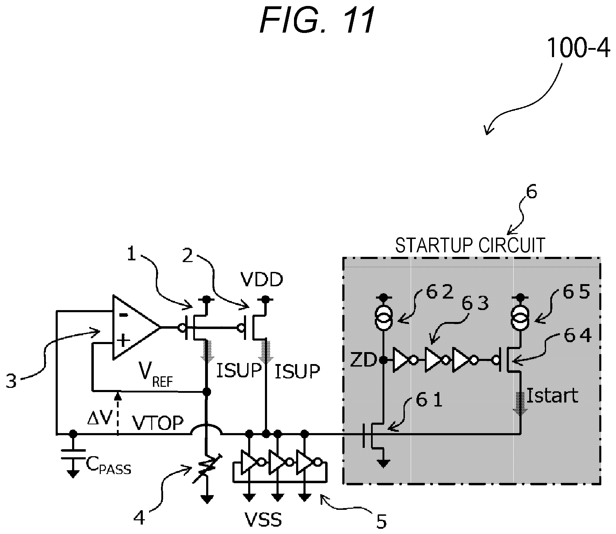

Fig. 11 is a circuit diagram illustrating a configuration of a circuit device 100-4 according to Example 4 of the first embodiment of the present technology. The circuit device 100-4 has a configuration substantially similar to that of the circuit device 100-1 according to Example 1, except that the startup circuit 6 is added and the reference resistor 4 has a stepwise adjustment function. From another point of view, the circuit device 100-4 has a configuration substantially similar to the configuration in which the voltage follower 8, the buffer 7, the level shifter 9, and the masking circuit 10 are removed from the circuit device 100-3 according to Example 3.

In the circuit device 100-4, as illustrated in Fig. 11, the startup circuit 6 ensures convergence to a desired state by avoiding abnormal convergence of the negative feedback loop (NFBL) by the negative feedback control unit including the PMOS transistors 1 and 2, the operational amplifier 3, the reference resistor 4, and the inverter ring 5.

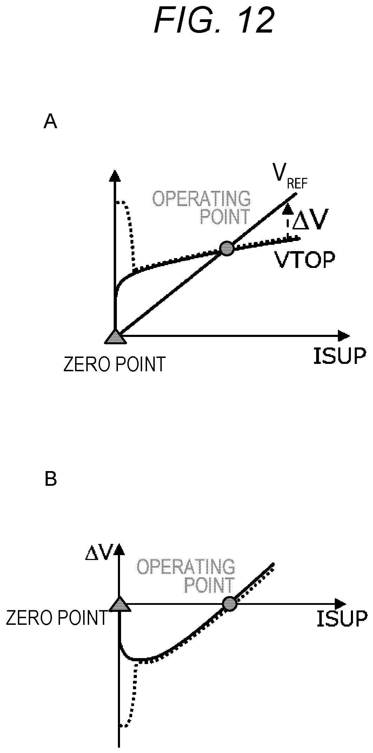

Fig. 12A is a graph illustrating a current-voltage characteristic of the inverter ring 5 of the circuit device 100-4 in Fig. 11. Fig. 12B is a graph illustrating a relationship between a current of the inverter ring 5 of the circuit device 100-4 of Fig. 11 and a residual voltage in the negative feedback control unit.

Meanwhile, in a case where the startup circuit 6 is not provided, a desirable convergence state and an abnormal convergence state may occur in the NFBL.

Horizontal axes in Figs. 12A and 12B represent a power supply current ISUP which is a drain current common to the PMOS transistors 1 and 2. In Fig. 12A, a vertical axis represents a voltage, and a voltage $V_{REF}$ applied to the reference resistor 4 by ISUP and the power supply voltage VTOP of the inverter ring 5 are plotted. In Fig. 12B, a differential voltage $\Delta V$ between $V_{REF}$ as the non-inverting input and VTOP as the inverting input of the operational amplifier 3 is plotted. In the circuit device 100-4, the function of the NFBL causes convergence to a so-called virtual short state in which the non-inverting input $V_{REF}$ and the inverting input VTOP of the operational amplifier 3 have the equal voltages.

An operating point indicated by a circle in Figs. 12A and 12B represents a desirable convergence state in which the non-inverting input $V_{REF}$ and the inverting input VTOP are virtually short-circuited at the current value ISUP which is not 0, and oscillation is made at an oscillation frequency with low temperature dependency due to the supply of the power supply current ISUP to the inverter ring 5. On the other hand, an operating point indicated by a triangle mark in Figs. 12A and 12B is a virtual short state established when the current value of ISUP is 0 and the non-inverting input $V_{REF}$ and the inverting input VTOP are also 0. This operating point is an undesirable abnormal state in which the inverter ring 5 does not oscillate although the NFBL is stable, and is an operating point called a zero point.

<Startup circuit>

As illustrated in Fig. 11, the startup circuit 6 for avoiding convergence to an abnormal state and reliably achieving a desired convergence state includes an NMOS transistor 61, a current source load 62, an inverter chain 63, a PMOS transistor 64, and a current source 65. A gate of the NMOS transistor 61 is connected to VTOP, which is the inverting input of the operational amplifier 3 and is also a power supply voltage of the inverter ring 5, and the NMOS transistor 61 is cut off when the voltage value of VTOP is a voltage so low that the inverter ring 5 cannot be oscillated. A drain of the NMOS transistor 61 is connected to the current source load 62 at a node ZD, and a voltage value of ZD is raised to the power supply potential VDD in a case where a voltage value of VTOP is low as described above and the NMOS transistor 61 is cut off. The inverter chain 63 binary-quantizes and inverts the voltage at the node ZD. That is, when the voltage at the node ZD is higher than a threshold of the inverter, the output of the inverter chain 63 becomes the reference potential VSS. A gate of the PMOS transistor 64 is driven by the output of the inverter chain 63, and conducts in a case where the voltage value of VTOP is low as described above. Due to the conduction of the PMOS transistor 64, the output current of the current source 65 flows into VTOP, which is the inverting input of the operational amplifier 3 and is also a power supply voltage of the inverter ring 5, and charging is performed such that the voltage value of VTOP is separated from 0 V.

Therefore, a relationship among ISUP, which is a current value of a drain current of the PMOS transistors 1 and 2 in a case where the startup circuit 6 is present, the voltage $V_{REF}$ applied to the reference resistor 4, and the power supply voltage VTOP of the inverter ring 5 is a curve as indicated by a dotted line in Figs. 12A and 12B, and a state in which $V_{REF}$ and VTOP are virtually short-circuited is only one point with the circle. Even if the loop falls into a state close to abnormal convergence, the startup circuit 6 prevents convergence to that state and ensures convergence to a desired state. Thus, convergence to the zero point is avoided by the startup circuit 6, and the inverter ring 5 reliably oscillates.

Note that, also in the circuit device 100-3 according to Example 3, the startup circuit 6 can have a configuration similar to the case of the circuit device 100-4.

Meanwhile, in the circuit device 100-3 (see Fig. 8) according to Example 3, a toggle signal of the oscillated inverter ring 5 is used by being transmitted to various blocks in the semiconductor integrated circuit via the buffer 7 and the level shifter 9. Since an output of the inverter ring 5 is the toggle signal that reciprocates between the reference potential VSS and the power supply voltage VTOP, the output is first input to the buffer 7 in which the reference potential is VSS, the power supply is VTOP, and the CMOS inverter is configured as a single or multistage.

In a case where the number of inverter stages constituting the ring is small, the toggle signal of the inverter ring 5 has a waveform that is not a rectangular waveform but is close to a sine wave. In the buffer 7 including the inverter INV applied with the same power supply voltage VTOP as that of the inverter ring 5 and having the same PMOS/NMOS ratio as that of the inverter ring 5, the input threshold is optimal for the toggle signal. Moreover, when the toggle signal is propagated through the buffer 7 by increasing a ratio of a MOS driving force to the load capacitor of the inverter INV in the buffer 7 to be larger than a ratio of the MOS driving force to the load capacitor of the inverter ring 5, and the toggle signal is output, the toggle signal is shaped into a waveform close to a rectangular wave suitable as a clock signal.

However, when ISUP, which is the drain current of the PMOS transistor 2, is divided into the inverter ring 5 and the buffer 7, Equation (3) above on the premise that ISUP contributes to oscillation of all the inverter rings 5 is not satisfied. As a result, Equation (8) above is not satisfied, so that an oscillation frequency with low temperature dependency cannot be obtained.

<Voltage follower>

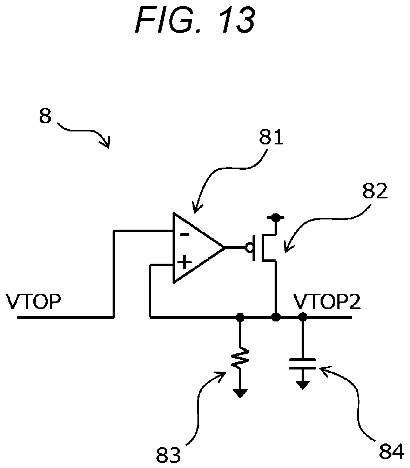

Therefore, in order to oscillate the inverter ring 5 at an oscillation frequency with low temperature dependency based on Equation (8) above, the power supply of the inverter ring 5 and the power supply of the buffer 7 are separated, that is, a buffer power supply VTOP2 having a voltage equal to VTOP as the power supply of the inverter ring 5 is generated using the voltage follower 8 and supplied to the buffer 7. For example, as illustrated in Fig. 13, the voltage follower 8 includes an operational amplifier 81, a PMOS transistor 82, an idle resistor 83, and a smoothing capacitor 84. A voltage value of VTOP2 is a non-inverting input of the operational amplifier 81, and is equal to a voltage value of the non-inverting input VTOP due to virtual short of the NFBL including the operational amplifier 81 and the PMOS transistor 82. The PMOS transistor 82 supplies, to the buffer 7 and the idle resistor 83, a power supply current for applying the same voltage as VTOP to the buffer power supply VTOP2. The idle resistor 83 causes an idle current for adjusting an operating point of the PMOS transistor 82 to flow, thereby increasing a stability margin of the NFBL. The smoothing capacitor 84 performs smoothing such that VTOP2 functions as the power supply of the buffer 7.

Meanwhile, in the circuit device 100-3 (see Fig. 8) according to Example 3, an output signal of the buffer 7 is converted into the toggle signal that reciprocates between the reference potential VSS and the power supply potential VDD by the level shifter 9, and becomes a clock signal that can be used as an input to a CMOS logic circuit.

<Level shifter>

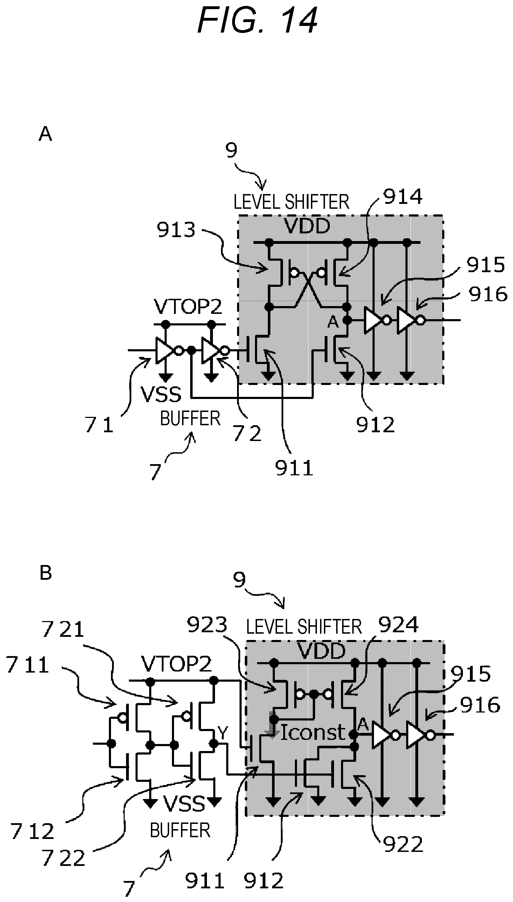

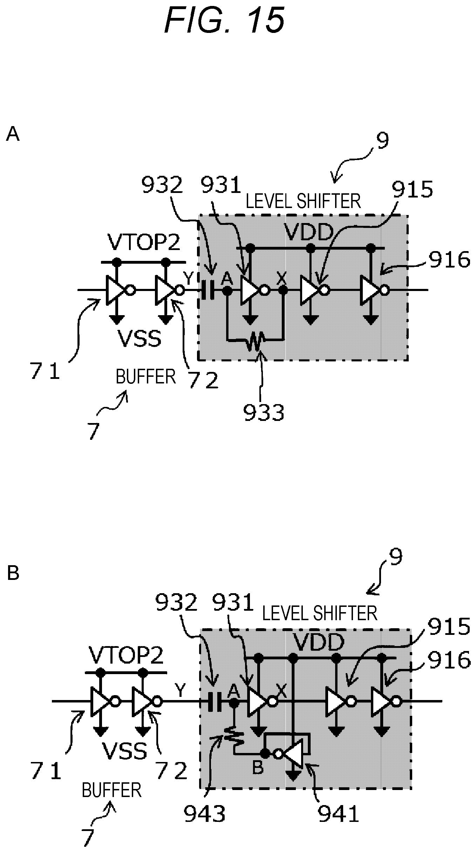

Figs. 14A and 14B are diagrams illustrating Configuration examples 1 and 2 of the level shifter 9 of the circuit device 100-3 in Fig. 8, respectively. Figs. 15A and 15B are diagrams illustrating Configuration examples 3 and 4 of the level shifter 9 of the circuit device 100-3 in Fig. 8, respectively.

Configuration example 1 of the level shifter 9 illustrated in Fig. 14A includes an NMOS transistor 911 whose gate is a final stage output of the buffer 7, an NMOS transistor 912 whose gate is an output one stage before the final stage output of the buffer 7, a cross-coupled load PMOS including PMOS transistors 913 and 914 connected to drains of the NMOS transistors 911 and 912, and inverter chains 915 and 916 whose inputs are drain connection points A of the NMOS transistor 912 and the PMOS transistor 914. Gate sizes of the NMOS transistors 911 and 912 and the PMOS transistors 913 and 914 are set so that the drains of the NMOS transistors 911 and 912 in a conducting state can pull a current larger than a drain current flowing out of the PMOS transistors 913 and 914 in a conducting state. As a result, a small amplitude buffer output that is toggling between VTOP2 and VSS is enlarged to a large amplitude of toggling from approximately VSS to VDD at the connection point A. The inverter chains 915 and 916 shape a toggle signal at the point A and output a clock signal at a CMOS logic level.

Configuration example 2 of the level shifter 9 illustrated in Fig. 14B is different from Configuration example 1 of Fig. 14A in that the gate of the NMOS transistor 911 is connected to VTOP2 that is the power supply of the buffer 7, an NMOS transistor 922 is connected in parallel with the NMOS transistor 912, and load PMOS 923 and 924 form a current mirror. When an output Y of the buffer 7 is at a high level, that is, when the NMOS transistors 912 and 922 conduct at the VTOP2 voltage, a total current is twice a current Iconst that the NMOS transistor 911 normally allows to flow. Since the current flowing in the load PMOS 924 is Iconst, a voltage at the drain connection point A between the NMOS transistors 912 and 922 and the load PMOS 924 decreases to a voltage close to VSS. Conversely, when the output Y of the buffer 7 is at a low level, that is, VSS, the NMOS transistors 912 and 922 are cut off, so that the voltage at the connection point A is VDD. The inverter chains 915 and 916 shape a toggle signal at the point A and output a clock signal at a CMOS logic level.

Configuration example 3 of level shifter 9 illustrated in Fig. 15A includes an inverter 931, a coupling capacitor 932 connected between an input A of the inverter 931 and the output Y of the buffer 7, a feedback resistor 933 that connects the input A and an output X of the inverter 931, and the inverter chains 915 and 916 to which the output X of the inverter 931 is input. A potential at the point A is substantially fixed to a threshold voltage of the inverter 931 by an action of negative feedback (NFB) formed by the inverter 931 and the feedback resistor 933. In the coupling capacitor 932 connected between the input A (fixed potential) and the output Y, which is toggling between VTOP2 and VSS, of the buffer 7, an AC current whose direction changes according to the toggle flows, and the AC current flows through the feedback resistor 933 to fluctuate the voltage of X. This voltage fluctuation is a toggle whose average voltage is the threshold voltage of the inverter 931, and the inverter chains 915 and 916 shape a toggle signal at the point X and output a clock signal of a CMOS logic level.

Configuration example 4 of the level shifter 9 illustrated in Fig. 15B is different from Configuration example 3 of Fig. 15A in that a bias potential is applied to the input A of the inverter 931 via a bias resistor 943 from the output of an inverter 941 whose input and output are short-circuited, instead of providing the feedback resistor 933. A signal generated at the point A by the coupling capacitor 932 and the bias resistor 943 has a waveform obtained by performing voltage shifting on a waveform of the output Y of the buffer 7 so that an average voltage becomes the threshold voltage of the inverter 931. This waveform is shaped by the inverter chains 915 and 916 and output as a clock signal of the CMOS logic level.

(Example 5)

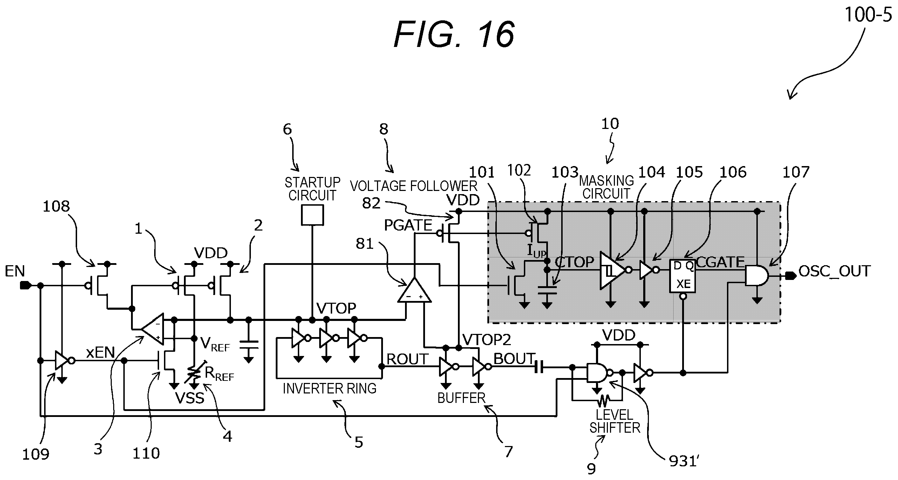

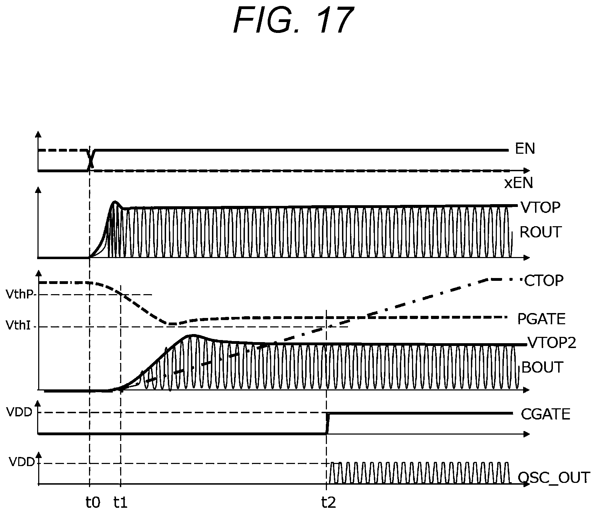

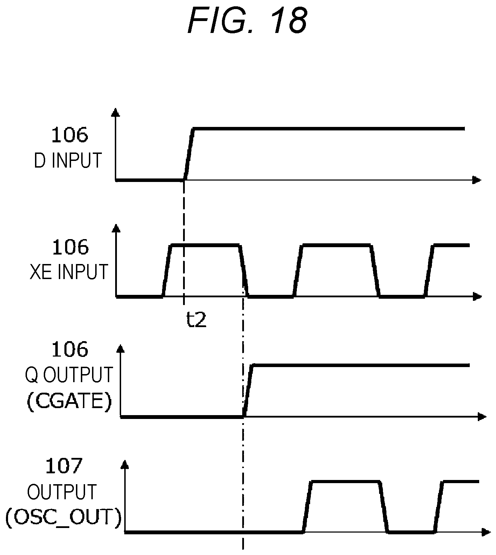

Fig. 16 is a circuit diagram illustrating a configuration of a circuit device 100-5 according to Example 5 of the first embodiment of the present technology. Fig. 17 is a timing chart illustrating a voltage change at a time of activation of the circuit device 100-5 of Fig. 16. Fig. 18 is a timing chart illustrating an input signal to a D latch 106, an output signal from the D latch 106, and an output signal of an AND gate 107.

Meanwhile, in the circuit device 100-3 (see Fig. 8) according to Example 3, an output of the level shifter 9 is output as a device output OSC_OUT via the masking circuit 10. The masking circuit 10 is provided for blocking and preventing an output of an undesirable oscillation waveform having an inaccurate frequency immediately after activation of the inverter ring 5.

<Masking circuit>

As illustrated in Fig. 16, in circuit device 100-5, the masking circuit 10 includes: a delay circuit including an NMOS transistor 101, a PMOS transistor 102, an integration capacitor 103, a hysteresis inverter 104, and an inverter 105; and a clock enabler circuit including the D latch 106 and the AND gate 107.

Furthermore, the circuit device 100-5 includes a disable PMOS 108 having a gate connected to an EN input and a drain connected to a common gate of the PMOS transistors 1 and 2, an inverter 109 configured to perform logic inversion of EN to obtain xEN, and a disable NMOS 110 having a gate connected to xEN and a drain connected to VTOP. When the EN input is at a low level, that is, VSS, xEN is at a high level, that is, VDD, and the disable PMOS 108 and the disable NMOS 110 both are electrically conducted. As a result, a voltage of the common gate of the PMOS transistors 1 and 2 is raised to approximately VDD, and VTOP is lowered to approximately VSS. As a result, the power supply current ISUP is not supplied to the inverter ring 5, and the inverter ring 5 is brought into a disabled state in which oscillation is stopped. At this time, the integration capacitor 103 is discharged by conduction of the NMOS transistor 101, and a voltage CTOP thereof becomes equal to VSS.

A feedback gate 931' of the level shifter 9 illustrated in Fig. 16 is obtained by replacing the inverter 931 of Fig. 15A with a NAND gate. Since one of inputs is EN, an output of the level shifter 9 is fixed to low when the EN input is at the low level. When the EN input becomes a high level, the NAND gate becomes the same as the inverter with respect to the input from the buffer 7, and the level shifter 9 illustrated in Fig. 16 becomes equivalent to the circuit of Fig. 15A.

Fig. 17 is a waveform diagram illustrating progress of activation of the circuit device 100-5 of Fig. 16 after the EN input rises from low to high. At time t0, EN transitions from low to high, and xEN transitions from high to low. Thereafter, both the disable PMOS 108 and the disable NMOS 110 are cut off. VTOP is raised by the startup circuit 6, and NFB is separated from of zero point with VTOP = 0 and ISUP = 0 to transition to a normal convergence state. The voltage follower 8 raises VTOP2 so as to follow VTOP. In this process, a voltage of a gate PGATE of the PMOS transistor 82 gradually decreases from VDD, and reaches a PMOS threshold voltage VthP at time t1. After this time, the PMOS transistor 102 conducts and charges the integration capacitor 103. When the voltage CTOP rises due to this charging and reaches a threshold VthI of the hysteresis inverter 104 at time t2, an output of the hysteresis inverter 104 changes from high to low, and an output of the inverter 105 changes from low to high. A D input end of the D latch 106 is connected to an output end of the inverter 105, and an XE input is connected to an output end of the level shifter 9. The D latch 106 enters a transparent state when the XE input is low, and enters a latched state when the XE input is high. If the XE input is low when the D input rises from low to high, a Q output CGATE of the D latch 106 immediately rises to high. If the XE input is high when the D input rises from low to high as in Fig. 18, the Q output CGATE of the D latch 106 waits for the XE input to fall low and then rises to high. In any case, when AND logic of CGATE and the output of the level shifter 9, which is also the XE input, is taken in the AND gate 107, the output OSC_OUT does not lack a part of a width of an input high pulse even if the D input of the D latch 106 rises at any timing, and becomes a high pulse having a constant width.

The masking circuit 10 masks a pulse having an unstable frequency when VTOP and VTOP2 do not sufficiently rise or a pulse having a small amplitude that is uncertain whether or not the pulse passes through the level shifter 9, to prevent the pulse from being output to the outside of the circuit device 100-5. A high pulse width of the device output has the same stable pulse width as a steady pulse following the first pulse, and a short pulse lacking the width is not output as OSC_OUT.

The circuit device according to the first embodiment described above (the circuit devices 100-1 to 100-5 according to Example 1 to 5) includes the inverter ring 5 (ring oscillator) including a plurality of inverters INV connected in a ring shape, and the drive circuit 50 configured to drive the inverter ring 5, and the drive circuit 50 is configured to suppress a change in oscillation frequency of the inverter ring 5 due to a temperature change.

According to the circuit device according to the first embodiment, it is possible to provide a circuit device (oscillator) capable of stabilizing the oscillation frequency of the inverter ring 5 at any frequency.

Furthermore, according to the circuit device according to the first embodiment, the inverter ring having low temperature dependency of the oscillation frequency can be built in a semiconductor integrated circuit without using an external component. Moreover, since it is not necessary to use a spiral inductor that occupies a large area and requires a low impedance wiring layer, the inverter ring can be manufactured at low cost.

Moreover, in the circuit device according to the first embodiment, the oscillation frequency can be freely adjusted and set not only at a time of manufacturing but also after manufacturing, and the temperature dependency of the frequency is low even if the oscillation frequency is adjusted and set to any frequency. Furthermore, the circuit device according to the first embodiment can be reliably activated as an oscillator without malfunctioning, and can output only a clock having a stable frequency and pulse width, without outputting a clock having an unstable frequency or an excessively short pulse width even at a time of activation.

Whereas, Patent Document 1 (Japanese Patent Application Laid-Open No. H03-252216) discloses a technique of stabilizing a center frequency as VCO by supplying a voltage that does not depend on a power supply voltage and an operating temperature, as a power supply of an inverter ring. However, since the technique is a stabilization method that does not allow for fluctuation of a MOS threshold due to the operating temperature, temperature dependency of the center frequency is high. Furthermore, the oscillation frequency variations due to manufacturing variations of the MOS threshold cannot be suppressed.

Furthermore, Patent Document 2 (Japanese Patent Application Laid-Open No. 2004-080550) discloses a technique of supplying a power supply current to an inverter ring for obtaining an oscillation frequency that does not depend on an operating temperature. However, a current value at which a supply current is independent of temperature is fixed to a specific value and cannot be freely selected. Therefore, the oscillation frequency at which temperature dependency is low cannot be freely selected, and is limited to a specific value. Moreover, even if a constant value of a current having no temperature dependency is supplied, the oscillation frequency of the inverter ring has temperature dependency, and thus the temperature dependency becomes high at the limited oscillation frequency.

Furthermore, Patent Document 3 "Japanese Patent Application Laid-Open No. 2001-068976" discloses a supply circuit of an inverter ring power supply voltage in which an oscillation frequency has low dependency on a power supply voltage, manufacturing variations of a MOS threshold, and an operating temperature, but the oscillation frequency cannot be freely selected also in this circuit.

<<2. Circuit device according to second embodiment of present technology>>

Hereinafter, a circuit device according to a second embodiment of the present technology will be described in detail with some examples. The circuit device according to the second embodiment can be applied to more types of inverter rings, and is capable of oscillation at an oscillation frequency with lower temperature dependency.

(Example 1)

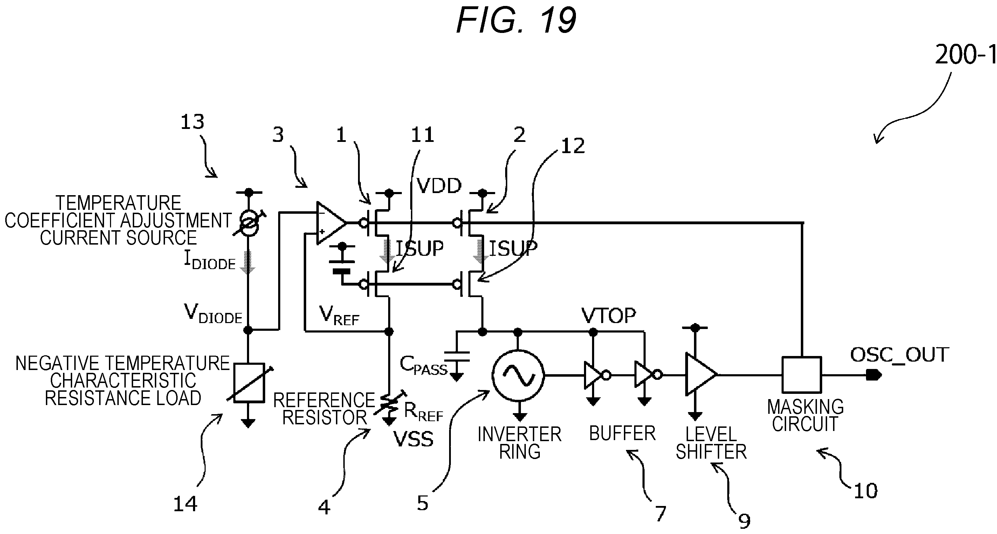

Fig. 19 is a circuit diagram illustrating a configuration of a circuit device 200-1 according to Example 1 of the second embodiment of the present technology. The circuit device 200-1 is different from the circuit device 100-3 (see Fig. 8) according to Example 3 of the first embodiment in the following points.

In the circuit device 200-1, a negative feedback control unit performs negative feedback control on at least a part of a power supply current ISUP so as to be proportional to a voltage $V_{DIODE}$ having a negative temperature characteristic.

As illustrated in Fig. 19, the negative feedback control unit includes a temperature coefficient adjustment current source 13 that is a current source for adjustment of a temperature coefficient, and a negative temperature characteristic resistance load 14 that is a resistor having a negative temperature characteristic (temperature characteristic of negative) connected to the temperature coefficient adjustment current source 13, and the negative feedback control unit generates the voltage $V_{DIODE}$ by using the temperature coefficient adjustment current source 13 and the negative temperature characteristic resistance load 14.

The negative feedback control unit includes a reference resistor 4 configured to define a ratio between the voltage $V_{DIODE}$ and the power supply current ISUP and having a variable resistance value.

In the circuit device 200-1, a cascode transistor 11 is inserted between a drain of a PMOS transistor 1 and the reference resistor 4, a cascode transistor 12 is inserted between a drain of a PMOS transistor 2 and a power supply voltage VTOP of an inverter ring 5, and a common bias is applied to gates of the cascode transistors 11 and 12 to adjust drain voltages of the PMOS transistors 1 and 2 to be substantially the same. An inverting input of an operational amplifier 3 is not connected to VTOP, but is connected to the connection point $V_{DIODE}$ between the temperature coefficient adjustment current source 13 and the negative temperature characteristic resistance load 14. The startup circuit 6 included in the circuit device 100-3 of Fig. 8 is not provided in the circuit device 200-1. This is because a convergence state of the NFBL formed by the operational amplifier 3 only exists at an operating point at which the non-inverting input $V_{REF}$ is virtually short-circuited to the positive voltage $V_{DIODE}$, which is not 0 and is determined by the temperature coefficient adjustment current source 13 and the negative temperature characteristic resistance load 14.

In the circuit device 200-1, a power supply of a buffer 7 is shared with a power supply of the inverter ring 5, and the voltage follower 8 included in the circuit device 100-3 of Fig. 8 is not provided in the circuit device 200-1. Therefore, the drain current ISUP of the PMOS transistor 2 is divided into the inverter ring 5 and the buffer 7. Equation (8) above indicating that the temperature dependency of the oscillation frequency of the inverter ring 5 is low is based on the premise that all ISUP, which is a drain current of the PMOS transistor 2, is used for charging and discharging a load capacitor C of an inverter INV of the inverter ring 5, and thus Equation (8) above is not satisfied in a case where ISUP includes the power supply current of the buffer 7.

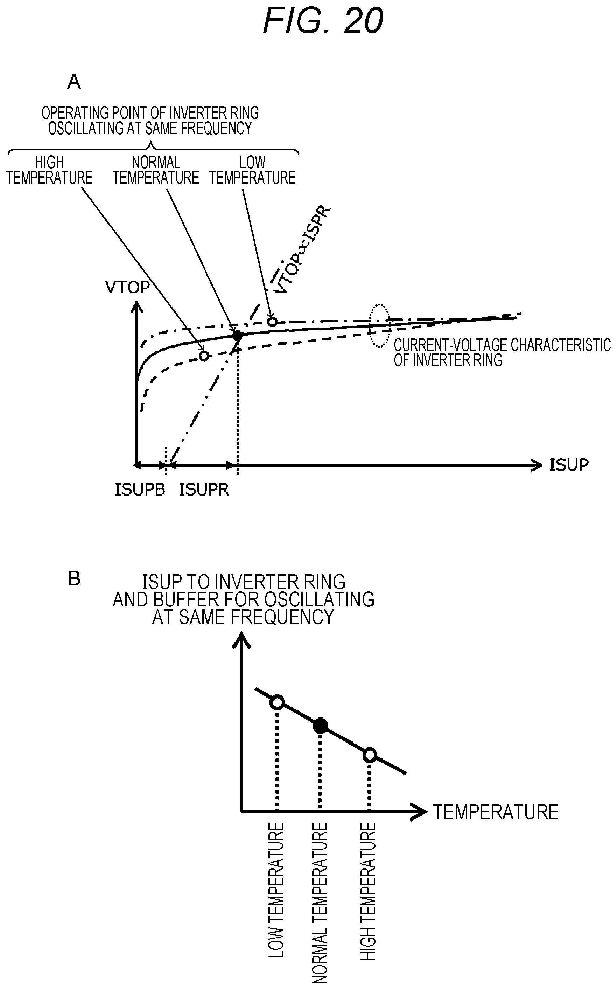

Fig. 20A is a graph illustrating a relationship between a current-voltage characteristic of the inverter ring 5 of the circuit device 200-1 of Fig. 19 and a target set value of the oscillation frequency. Fig. 20B is a graph illustrating temperature dependency of a power supply current at an operating point of the inverter ring 5 oscillating at the same frequency.

As illustrated in Fig. 20A, when ISUP is considered separately for a current ISUPR flowing through the inverter ring 5 and a current ISUPB flowing through the buffer 7, an operating point at normal temperature represented by a black circle in Fig. 20A satisfies the following equation derived from Equation (5) above.

$$\text{VTOP} \propto \text{ISUPR}/(3 \times \text{C}) \quad \cdots(9)$$

A horizontal intercept of a two-dot chain line in Fig. 20A representing Equation (9) above corresponds to the current ISUPB flowing through the buffer 7. When the inverter ring 5 oscillates at temperature other than normal temperature at the same frequency as that of the normal temperature, operating points of the inverter ring 5 are not arranged on a straight line passing through the origin, and are not arranged on the two-dot chain line because ISUPB changes with temperature, but the operating points exist in the vicinity of these lines.

The current ISUP necessary for oscillating at the same frequency has temperature dependency as illustrated in Fig. 20B. A temperature coefficient of the temperature dependency is not unique because it depends on the temperature characteristic of the buffer 7, but generally has the following tendency. In a miniaturized CMOS having a power supply voltage of around 1 V, the inverter ring 5 is driven at a voltage lower than 1 V, typically around 0.5 V. Since a threshold voltage of such a miniaturized CMOS is generally 0.2 to 0.4 V, the operating point of the inverter ring 5 is usually in a region on a lower current side than ISUP where high temperature, normal temperature, and low temperature current-voltage characteristic curves intersect in Fig. 20A. In this case, as illustrated in Fig. 20B, the temperature dependency of the current at the operating point of the inverter ring 5 oscillating at the same frequency has a negative temperature coefficient.

In order to cause the inverter ring 5 to oscillate at a frequency independent of temperature, in the circuit device 200-1, the voltage $V_{DIODE}$ generated at the connection point between the temperature coefficient adjustment current source 13 and the negative temperature characteristic resistance load 14 is applied to the inverting input of the operational amplifier 3. NFB by the operational amplifier 3 and the PMOS transistor 1 causes the non-inverting input $V_{REF}$ of the operational amplifier 3 to be equal to $V_{DIODE}$. Since $V_{REF}$ is a voltage applied to the reference resistor 4 into which ISUP is poured, the following Equation (10) is satisfied.

$$ISUP = V_{REF}/R_{REF} = V_{DIODE}/R_{REF} \quad \cdots (10)$$

By generating $V_{DIODE}$ having an appropriate temperature coefficient, when ISUP illustrated in Fig. 20B is supplied to the inverter ring 5 and the buffer 7, the inverter ring 5 oscillates at an oscillation frequency having low temperature dependency. Note that $R_{REF}$ may be made variable by using the circuit of Fig. 9 in the reference resistor 4.

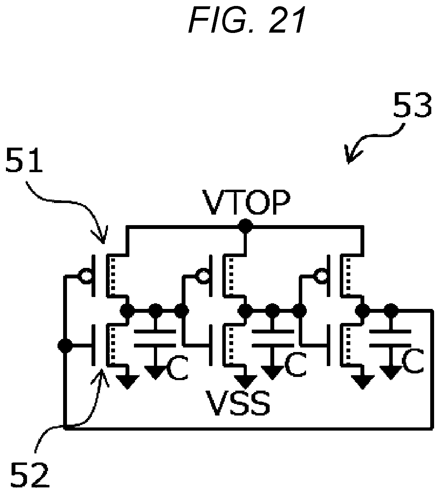

For the circuit device 200-1 in Fig. 19, an inverter ring 53 including a leaky PMOS transistor 51 and a leaky NMOS transistor 52 as in Fig. 21 can be used. Even when the gate voltage of the PMOS transistor 51 is VTOP, the drain current continues to flow without being cut off sufficiently. Even when the gate voltage of the NMOS transistor 52 is VSS, the drain current continues to flow without being cut off sufficiently. In the inverter ring 53 including such a transistor, a part of ISUP is consumed as a through current other than charging and discharging of the load capacitor C of the inverter in the inverter ring 53, and thus Equation (8) above is not satisfied. Therefore, even when the inverter ring 53 is used for the circuit device 100-3 in Fig. 8, the temperature dependency of the oscillation frequency is not reduced. However, in the circuit device 200-1 of Fig. 19 applied with the current ISUP of Equation (10) above for performing stable oscillation with low temperature dependency including the through current, a stable oscillation frequency with low temperature dependency can be obtained.

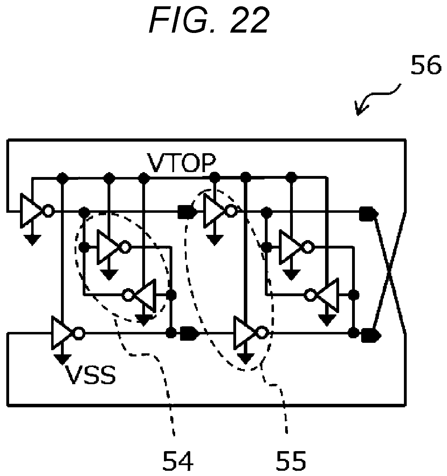

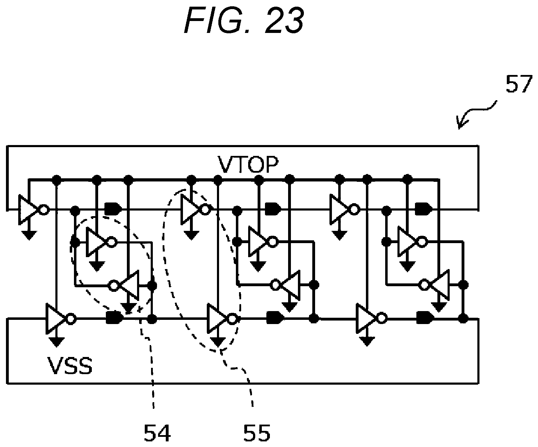

In differential inverter rings 56 and 57 in which a pseudo differential inverter pair 55 is annularly connected via a cross-coupled inverter pair 54 as illustrated in Figs. 22 and 23, a part of ISUP is consumed by the cross-coupled inverter, and thus Equation (8) above is not satisfied. Even in such inverter rings 56 and 57, a stable oscillation frequency with low temperature dependency can be obtained in the circuit device 200-1 of Fig. 19. From these differential inverter rings 56 and 57, multiphase clocks having uniform phase differences can be obtained.

<Temperature coefficient adjustment current source>

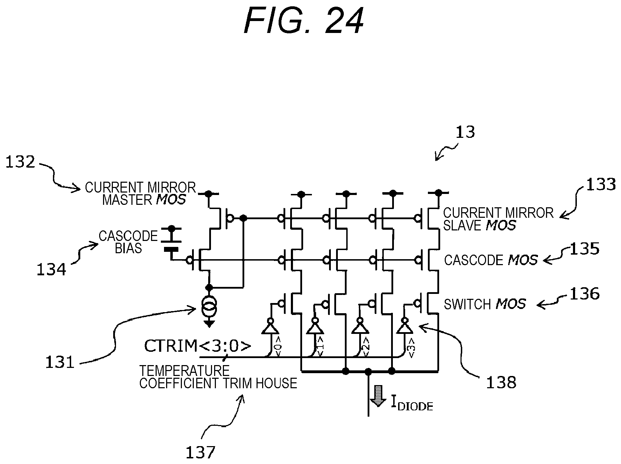

The temperature coefficient adjustment current source 13 of the circuit device 200-1 of Fig. 19 includes, for example, a circuit illustrated in Fig. 24. The temperature coefficient adjustment current source 13 includes a stabilization current source 131 that does not depend on a power supply voltage and temperature, and a current thereof is multiplied by a constant factor in a current mirror including a master MOS transistor 132 and a slave MOS transistor 133, and becomes a current $I_{DIODE}$ to be supplied to the negative temperature characteristic resistance load 14. A cascode MOS transistor 135 having a gate connected to a cascode bias 134 is inserted between the master MOS transistor 132 and the stabilization current source 131 and between the slave MOS transistor 133 and a switch MOS transistor 136. A temperature coefficient trim bus 137 controls a gate of the switch MOS transistor 136 via an inverter 138. In this circuit, the switch MOS transistor 136 corresponding to a bit at a high level in the temperature coefficient trim bus 137 is conducted, and the switch MOS transistor corresponding to a low level is cut off. When all the slave MOS transistors 133 have the same size, the current $I_{DIODE}$ becomes a current proportional to the number of bits set at the high level in the temperature coefficient trim bus 137. That is, the temperature coefficient trim bus 137 controls the current $I_{DIODE}$ as a thermometer code. If a gate width of the slave MOS transistor 133 corresponding to a least significant bit (LSB) of the temperature coefficient trim bus 137 is minimum, and a gate width corresponding to one upper bit of the temperature coefficient trim bus 137 is twice a gate width of a lower bit, the current $I_{DIODE}$ is a current proportional to a binary number represented by the temperature coefficient trim bus 137. That is, the temperature coefficient trim bus 137 controls the current $I_{DIODE}$ as a binary code.

<Negative temperature characteristic resistance load>

A resistance temperature coefficient of the negative temperature characteristic resistance load 14 generally changes according to a current. Therefore, by adjusting the supply current $I_{DIODE}$ to obtain a desired temperature coefficient, the circuit device 200-1 of Fig. 19 becomes an oscillator that oscillates at a stable oscillation frequency with low temperature dependency.

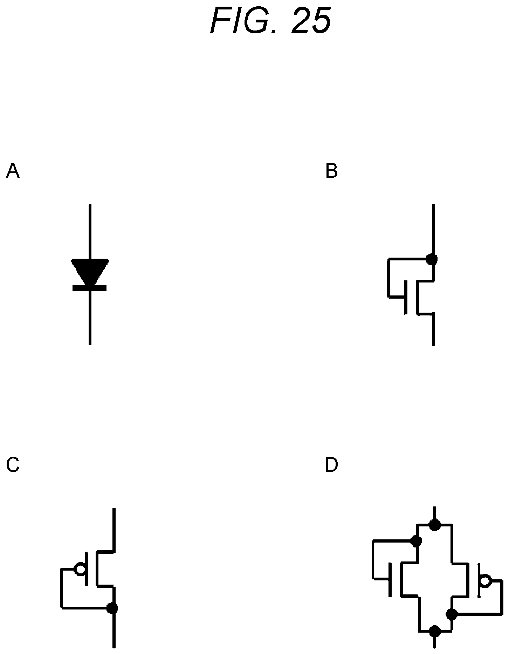

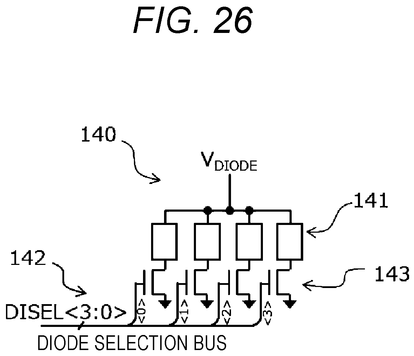

Figs. 25A to 25D are diagrams illustrating Configuration example 1 to 4 of the negative temperature characteristic resistance load 14. Fig. 26 is a diagram illustrating Configuration example 5 of the negative temperature characteristic resistance load. For the negative temperature characteristic resistance load 14 of the circuit device 200-1 of Fig. 19, a junction diode of Configuration example 1 illustrated in Fig. 25A, an NMOS diode of Configuration example 2 illustrated in Fig. 25B, a PMOS diode of Configuration example 3 illustrated in Fig. 25C, or a parallel connector of an NMOS diode and a PMOS diode of Configuration example 4 illustrated in Fig. 25D can be used. Furthermore, the negative temperature characteristic resistance load 14 may be a load circuit 140 that selectively conducts a plurality of negative temperature characteristic resistance elements 141 by a diode selection bus 142 and a switch MOS 143, which is Configuration example 5 illustrated in Fig. 26.

(Example 2)

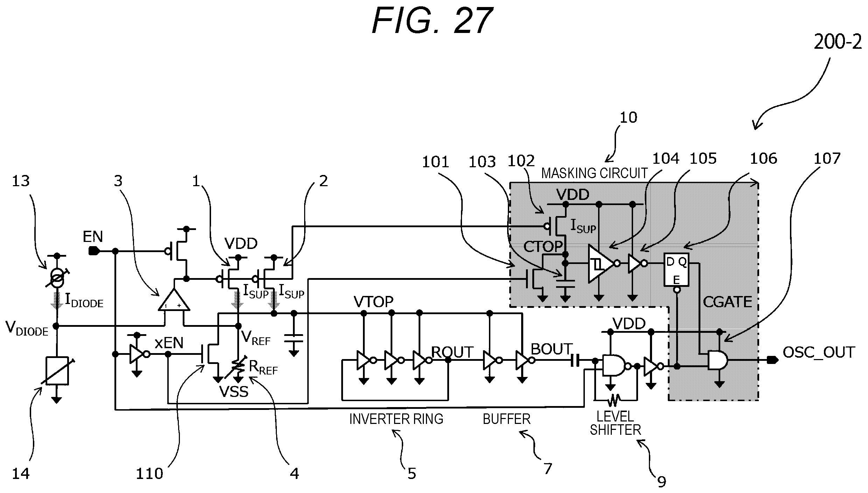

Fig. 27 is a circuit diagram illustrating a configuration of a circuit device 200-2 according to Example 2 of the second embodiment of the present technology.

The circuit device 200-2 of Fig. 27 includes an EN input terminal similarly to the circuit device 100-5 of Fig. 16. When an EN input is at a low level, the inverter ring 5 does not oscillate, and an output OSC_OUT is also fixed to L. When the EN input transitions to a high level, the inverter ring 5 starts to oscillate, but the output OSC_OUT remains fixed to the low level by the masking circuit 10 until an amplitude and a frequency are stabilized, and an inaccurate frequency or pulse width signal is not output to OSC_OUT, which is similar to the circuit device 100-5 in Fig. 16.

The circuit device 200-2 is different from the circuit device 100-5 of Fig. 16 in that the voltage $V_{DIODE}$ (negative temperature characteristic voltage) generated by the temperature coefficient adjustment current source 13 and the negative temperature characteristic resistance load 14 is input to the NFBL formed by the PMOS transistors 1 and 2, the operational amplifier 3, and the reference resistor 4, the buffer 7 receives power supply from the PMOS transistor 2 instead of the voltage follower, and a gate voltage of a PMOS transistor 102 in the masking circuit 10 is supplied from the operational amplifier 3 instead of the voltage follower.

In the circuit device 200-2, while the EN input is at the low level, the current ISUP is 0, and the inverter ring 5 does not oscillate. During this time, the output of the level shifter 9 is fixed to low, and an integration capacitor 103 in the masking circuit 10 is discharged by conduction of an NMOS transistor 101. When the EN input transitions to H, the NMOS transistor 101 is cut off, and the PMOS transistor 102 sharing a gate with the PMOS transistor 2 that supplies a current to the inverter ring 5 starts charging the integration capacitor 103. Until a voltage CTOP of the integration capacitor 103 reaches a threshold of a hysteresis inverter 104, a clock enabler circuit including a D latch 106 and an AND gate 107 cuts off an unstable signal from the buffer 7 and keeps the output OSC_OUT low. When the charging of the integration capacitor 103 proceeds and the voltage CTOP reaches the threshold of the hysteresis inverter 104, a D input of the D latch 106 transitions to high. At this time, the NFB is already stable, and the oscillation of the inverter ring 5 is stabilized. High of the D input propagates to an output CGATE of the D latch 106 only when the output of the level shifter 9 is low. A high pulse of the output of the level shifter 9 after CGATE transitions to high passes through the AND gate 107 and is output as OSC_OUT.

A circuit device (the circuit devices 200-1 and 200-2 according to Examples 1 and 2) according to the second embodiment described above includes an inverter ring including a plurality of inverters INV connected in a ring shape, and a drive circuit configured to drive the inverter ring, and the drive circuit is configured to suppress a change in oscillation frequency of the inverter ring due to a temperature change.

According to the circuit device according to the second embodiment, it is possible to provide a circuit device (oscillator) capable of stabilizing the oscillation frequency of the inverter ring at any frequency.

Furthermore, the circuit device according to the second embodiment can implement an oscillator including various types of inverter rings of a wide range of a process technology and having low temperature dependency of an oscillation frequency. As one example, a miniaturized CMOS technology having a large inverter through current can be used. Furthermore, it is also possible to oscillate a differential inverter ring including a CMOS pseudo differential inverter pair and capable of obtaining a multiphase clock having a uniform phase difference between phases, at an oscillation frequency having low temperature dependency.

<<3. Semiconductor integrated circuit according to third embodiment of present technology>>

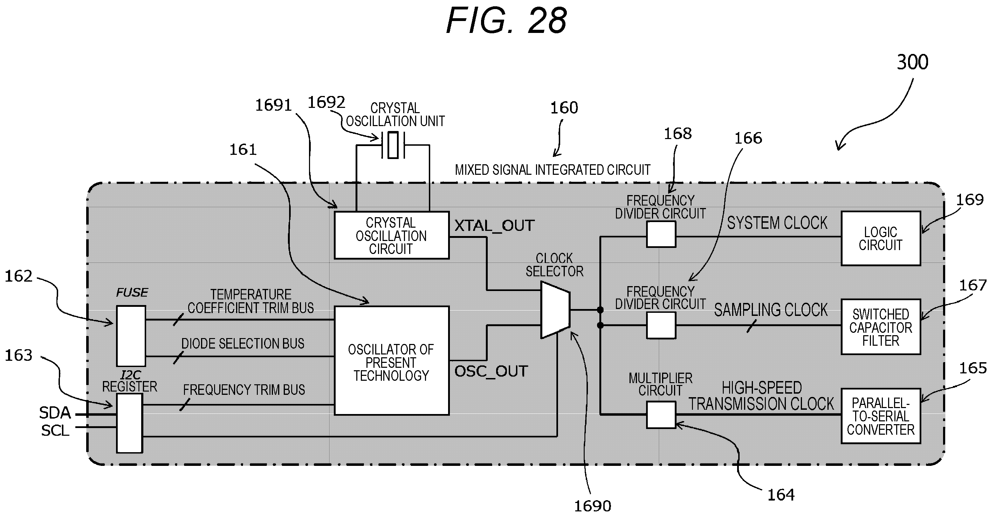

Fig. 28 is a circuit block diagram illustrating a configuration example of a semiconductor integrated circuit 300 according to a third embodiment of the present technology.

The semiconductor integrated circuit 300 includes a circuit device (oscillator) of the present technology, for example, the circuit device according to the first embodiment (any of the circuit devices 100-1 to 100-5 according to Examples 1 to 5) or the circuit device according to the second embodiment (any of the circuit devices 200-1 and 200-2 according to Examples 1 and 2), and the circuit device can serve as a clock oscillation source.

The semiconductor integrated circuit 300 can further include a crystal oscillator including a crystal oscillation circuit 1691 and a crystal unit 1692 (quartz crystal) that can serve as the clock oscillation source, and the clock oscillation source can be switched between the circuit device (oscillator) of the present technology and the crystal oscillator.

The semiconductor integrated circuit 300 includes a mixed signal integrated circuit 160. In an oscillator as the circuit device according to the present technology, for example, in an oscillator 161 (on-chip oscillator) in Fig. 28, a frequency trim bus is controlled by an I2C register 163, and a temperature coefficient trim bus and a diode selection bus are fixed to appropriate values with a fuse. An output OSC_OUT of the oscillator 161 is frequency-divided into an appropriate frequency by a frequency divider circuit 168, and supplied as a system clock of a logic circuit 169. Furthermore, OSC_OUT is frequency-divided into an appropriate frequency by a frequency divider circuit 166, and converted into a non-overlapping clock for driving a switched capacitor filter 167. Moreover, OSC_OUT is converted into a clock for high-speed transmission by a multiplier circuit 164 to drive a parallel-to-serial converter 165. The mixed signal integrated circuit 160 includes a clock selector 1690 controlled by the I2C register 163 and the crystal oscillation circuit 1691, and a resonance terminal of the crystal oscillation circuit 1691 is connected to the crystal unit 1692 outside the mixed signal integrated circuit 160. If the oscillator 161 satisfies system requirements, the mixed signal integrated circuit 160 may select the output OSC_OUT of the oscillator 161 as the clock oscillation source and may not implement the external crystal unit 1692. In a case where the system requires very high frequency stability, the crystal unit 1692 can be mounted and connected, and an output XTAL_OSC of the crystal oscillation circuit 1691 can be selected as the clock oscillation source to obtain a clock having frequency stability by the crystal unit 1692.

In the semiconductor integrated circuit 300 according to the third embodiment described above, in a case where extremely high frequency accuracy is required for a clock according to a system request of the mixed signal integrated circuit 160, an operation of the mixed signal integrated circuit 160 can be performed by a clock of the crystal oscillation circuit 1691 connected to the crystal unit 1692 outside the mixed signal integrated circuit 160. Otherwise, the operation of the mixed signal integrated circuit 160 can be performed by a clock of a frequency having low temperature dependency and generated only in the mixed signal integrated circuit 160 without having the crystal unit 1692 outside the mixed signal integrated circuit 160. That is, the semiconductor integrated circuit 300 can optimize a manufacturing cost and an electronic circuit board area of a device on which the mixed signal integrated circuit 160 is mounted, in trade-off with the system requirement for clock frequency accuracy.

<<4. Camera monitoring system according to fourth embodiment of present technology>>

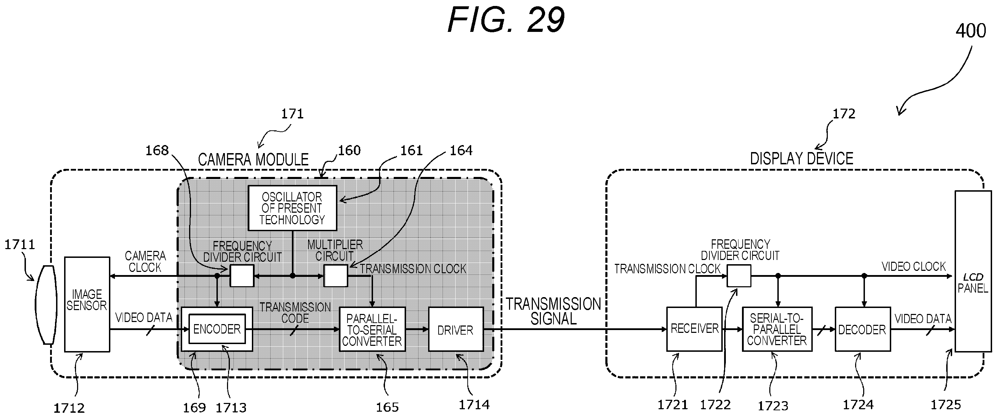

Fig. 29 is a circuit block diagram illustrating a configuration example of a camera monitoring system 400 according to a fourth embodiment of the present technology.

The camera monitoring system 400 includes, as an example, a camera module 171 and a display device 172 (external device). The camera module 171 includes a camera including: a circuit device (oscillator) of the present technology, for example, the circuit device according to the first embodiment (any of the circuit devices 100-1 to 100-5 according to Examples 1 to 5) or the circuit device according to the second embodiment (any of the circuit devices 200-1 and 200-2 according to Examples 1 and 2); and an image sensor 1712 in which the circuit device serves as a clock oscillation source. The camera outputs a clock from the circuit device to the display device 172 via a serial transmission path.

The camera module 171 and the display device 172 are remotely disposed, and video data is serially transmitted from the camera module 171 to the display device 172 via the serial transmission path. As a format of a serial transmission signal transmitted through the serial transmission path, for example, GVIF2 (Non-Patent Document: JEITA CP-6101B) is used.

The camera module 171 includes a mixed signal integrated circuit 160 including an oscillator 161 as an example of the circuit device (oscillator) according to the present technology. An output of the oscillator 161 is frequency-divided by a frequency divider circuit 168, and supplied as a camera clock from the mixed signal integrated circuit 160 to the image sensor 1712. The image sensor 1712 generates video data on the basis of a video image formed by a lens 1711, and sends the video data to an encoder 1713 that is a part of a logic circuit 169 of the mixed signal integrated circuit 160. A video signal coded by the encoder 1713 is converted into a serial bit string by a parallel-to-serial converter 165 driven with a high-speed transmission clock obtained by multiplying an output of the oscillator 161 in a multiplier circuit 164, and is output from the camera module 171 via a driver 1714. A transmission signal output from the camera module 171 is input to a receiver 1721 in the display device 172, and the serial bit string and the high-speed transmission clock are reproduced. The high-speed transmission clock is converted into a video clock by a frequency divider circuit 1722, and supplied to a serial-to-parallel converter 1723, a decoder 1724, and an LCD panel 1725. The serial bit string is reversely converted into video data by the serial-to-parallel converter 1723 and the decoder 1724, and supplied to the LCD panel 1725. The LCD panel 1725 displays a monitoring video image on the basis of the video clock and the video data.

According to the camera monitoring system 400 described above, the mixed signal integrated circuit 160 in the camera module 171 can drive the image sensor 1712 with a clock of a frequency generated without using a crystal unit (quartz crystal) and having low temperature dependency, convert the video signal into a serial transmission signal of a stable rate, and transmit the serial transmission signal to the display device 172 disposed remotely from the camera module 171. Since the crystal unit is not used for the camera module 171, a manufacturing cost of the camera module 171 is reduced, and an electronic circuit board in the module can be downsized. As a result, for example, it is possible to implement a camera monitoring system including a highly downsized camera module for constituting an electronic side mirror and an omnidirectional monitoring system.

<<5. Mobile object device according to fifth embodiment of present technology>>

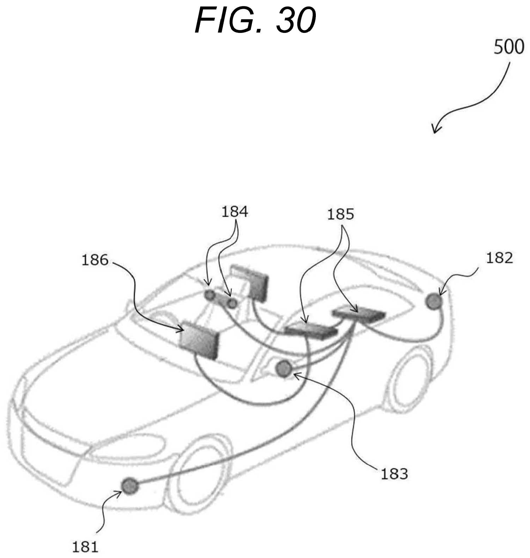

Fig. 30 is a diagram illustrating a configuration example of a mobile object device 500 according to a fifth embodiment of the present technology. As an example, the mobile object device 500 includes a plurality of cameras and a vehicle (for example, an automobile) as a mobile object on which the plurality of cameras is mounted.

Each camera includes: a circuit device (oscillator) of the present technology, for example, the circuit device according to the first embodiment (any one of the circuit devices 100-1 to 100-5 according to Examples 1 to 5) or the circuit device according to the second embodiment (any of the circuit devices 200-1 and 200-2 according to Examples 1 and 2), and an image sensor in which the circuit device serves as a clock oscillation source.

The mobile object device 500 includes a mobile object control system including a camera monitoring system similar to the camera monitoring system 400 according to the third embodiment. Reference numeral 181 denotes a side monitoring camera, reference numeral 182 denotes a rear monitoring camera, reference numeral 183 denotes an electronic side mirror, reference numeral 184 denotes a front monitoring and distance measurement camera, reference numeral 185 denotes a relay and video integration device, and reference numeral 186 denotes a display device. Video images captured by the cameras 181 to 184 are selected or integrated by the video integration device 185. If necessary, an alert graphic or the like indicating a dangerous article obtained from the distance measurement information is superimposed and displayed on the display device 186. This mobile object control system can be used for automated driving including, for example, an automatic brake, an automatic steering, an automatic accelerator, and the like.

Here, an automobile is taken as an example of the mobile object of the mobile object device according to the present technology, but the mobile object may be a motorcycle, an airplane (including a drone), a ship, a robot, or the like.

<<6. Modification of the present technology>>

The present technology is not limited to the embodiments described above, and various modifications are possible.

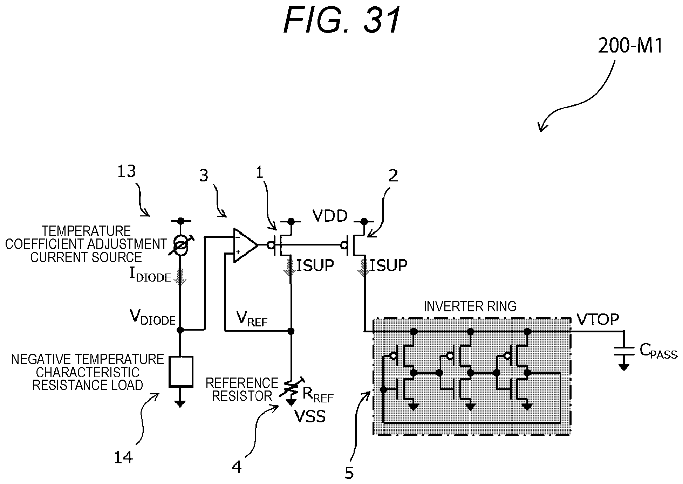

For example, a circuit device 200-M1 according to Modification 1 of the second embodiment illustrated in Fig. 31 has a configuration in which the buffer 7, the level shifter 9, and the masking circuit 10 are removed from the circuit device 200-1 according to Example 1 of the second embodiment. In the circuit device 200-M1, the load capacitor C is not provided in the inverter ring 5, but may be provided.

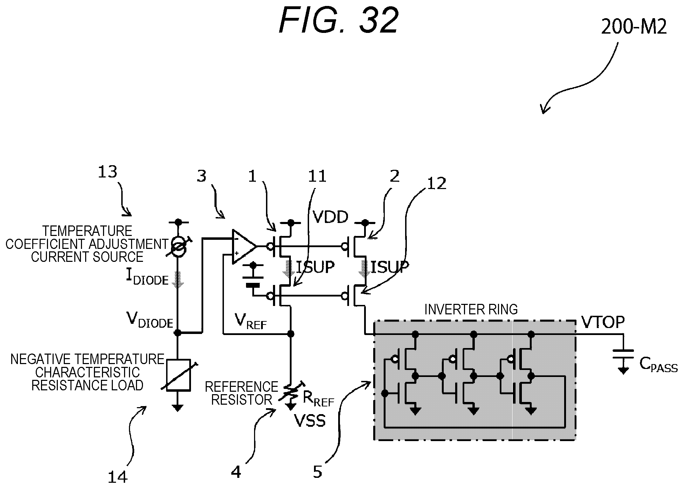

For example, in a circuit device 200-M2 according to Modification 2 of the second embodiment illustrated in Fig. 32, the negative temperature characteristic resistance load 14 is a resistance value selection type (variable type) so that a temperature gradient of $V_{DIODE}$ can be set in a wider range than that of the circuit device 200-M1 according to Modification 1 of the second embodiment. Moreover, in the circuit device 200-M2, the cascode transistors 11 and 12 are added such that $V_{REF}$ and VTOP are not equal in voltage, and current values of the power supply currents ISUP from the PMOS transistors 1 and 2 are not equal, similarly to the circuit device 200-M1, but are as close as possible.

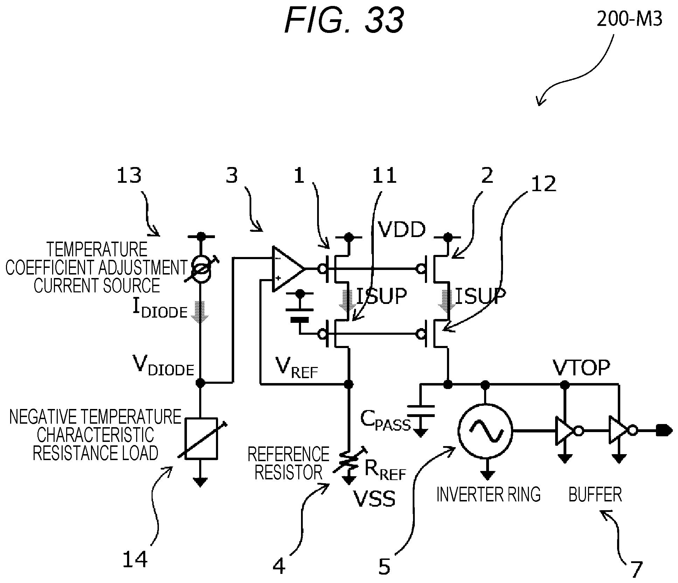

For example, a circuit device 200-M3 according to Modification 3 of the second embodiment illustrated in Fig. 33 is based on a configuration obtained by removing the level shifter 9 and the masking circuit 10 from the circuit device 200-1 according to Example 1 of the second embodiment. In the circuit device 200-M3, the negative temperature characteristic resistance load 14 is a resistance value selection type (variable type) so that a temperature gradient of $V_{DIODE}$ can be set in a wider range. Moreover, in the circuit device 200-M3, the cascode transistors 11 and 12 are added such that $V_{REF}$ and VTOP are not equal in voltage, and current values of the power supply currents ISUP from the PMOS transistors 1 and 2 are not equal, similarly to the circuit device 200-M1, but are as close as possible.

Some of the configurations of the circuit devices according to the individual embodiments (individual examples) described above and individual modifications may be combined within a range not contradictory to each other.

At least a part of the configuration of each of the circuit devices according to the first and second embodiments described above, the semiconductor integrated circuit according to the third embodiment described above, the camera according to the fourth embodiment described above, and the mobile object device according to the fifth embodiment described above can be replaced with a same effect material, an equivalent circuit, or the like.

Furthermore, the present technology may also adopt the following configurations.

(1) A circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

(2) The circuit device according to (1), in which the drive circuit includes a negative feedback control unit configured to perform negative feedback control of a power supply current on the basis of a power supply voltage of the ring oscillator, the power supply voltage being generated when at least a part of the power supply current is supplied to the ring oscillator.

(3) The circuit device according to (2), in which

substantially all of the power supply current is supplied to the ring oscillator, and
a ratio between the power supply voltage and the power supply current is substantially constant.

(4) The circuit device according to (3), in which

the negative feedback control unit includes a reference resistor configured to define the ratio, and
a temperature coefficient of a resistance value of the reference resistor is set to a predetermined value or less.

(5) The circuit device according to (3) or (4), in which

the ring oscillator includes a load capacitor connected to the inverter, and
a temperature coefficient of a capacitance value of the load capacitor is set to a predetermined value or less.

(6) The circuit device according to any one of (3) to (5), in which

the negative feedback control unit includes a reference resistor configured to define the ratio, and
a resistance value of the reference resistor is set according to a target set value of the oscillation frequency.

(7) The circuit device according to (6), in which the resistance value is set lower as the target set value is higher.

(8) The circuit device according to any one of (2) to (7), in which
the drive circuit includes:

a voltage follower; and
a buffer circuit,
substantially all of the power supply current is supplied to the ring oscillator, and the power supply voltage is supplied to the voltage follower, and
the power supply voltage reproduced by the voltage follower serves as a power supply of the buffer circuit.

(9) The circuit device according to (8), in which the drive circuit includes a level shifter configured to convert an output signal of the buffer circuit into a toggle signal that reciprocates between a reference potential and a power supply potential.

(10) The circuit device according to any one of (2) to (9), in which the drive circuit includes a startup circuit for avoidance of a zero point of the negative feedback control.

(11) The circuit device according to any one of (2) to (10), in which the drive circuit includes a masking circuit configured to mask an output signal of the ring oscillator immediately after activation.

(12) The circuit device according to any one of (2) to (11), in which the negative feedback control unit performs negative feedback control on the at least a part of the power supply current to be proportional to a voltage having a negative temperature characteristic.

(13) The circuit device according to (12), in which
the negative feedback control unit includes:

a current source for adjustment of a temperature coefficient of the voltage; and
a resistor having a negative temperature characteristic and connected to the current source, and
the negative feedback control unit generates the voltage by using the current source and the resistor.

(14) The circuit device according to (12) or (13), in which the negative feedback control unit includes a reference resistor configured to define a ratio between the voltage and the power supply current and having a variable resistance value.

(15) The circuit device according to any one of (12) to (14), in which the drive circuit includes a masking circuit configured to mask an output signal of the ring oscillator immediately after activation.

(16) A semiconductor integrated circuit including a circuit device, in which

the circuit device can serve as a clock oscillation source,
the circuit device including:

a ring oscillator including a plurality of inverters connected in a ring shape; and
a drive circuit configured to drive the ring oscillator, and
the drive circuit is configured to suppress a change in oscillation frequency of the ring oscillator due to a temperature change.

(17) The semiconductor integrated circuit according to (16), further including:

a crystal oscillator that can serve as a clock oscillation source, in which
the oscillation source can be switched between the circuit device and the crystal oscillator.

(18) A camera including:

a circuit device; and
a solid-state imaging device in which the circuit device serves as a clock oscillation source,
the circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

(19) The camera according to (18), in which a clock from the circuit device is output to an external device via a serial transmission path.

(20) A mobile object device including:

a camera; and
a mobile object on which the camera is mounted,
the camera including:

a circuit device; and
a solid-state imaging device in which the circuit device serves as a clock oscillation source,
the circuit device including:

a ring oscillator including a plurality of inverters connected in a ring shape; and
a drive circuit configured to drive the ring oscillator, in which
the drive circuit is configured to suppress a change in oscillation frequency of the ring oscillator due to a temperature change.

REFERENCE SIGNS LIST

100-1, 100-2, 100-3, 100-4, 100-5, 200-1, 200-2, 200-M1, 200-M2, 200-M3 Circuit device

1 PMOS transistor (part of drive circuit)

2 PMOS transistor (part of drive circuit)

3 Operational amplifier (part of negative feedback control unit)

4 Reference resistor (part of negative feedback control unit)

5, 53, 56, 57 Inverter ring (link oscillator)

6 Startup circuit

7 Buffer (buffer circuit)

8 Voltage follower

9 Level shifter

10 Masking circuit

13 Temperature coefficient adjustment current source (current source)

14 Negative temperature characteristic resistance load (resistor)

50 Drive circuit

140 Load circuit (resistor)

INV, INV1, INV2, INV3 Inverter

ISUP Power supply current

VTOP Power supply voltage

VDD Power supply potential

**Claims**

1. A circuit device comprising:

   a ring oscillator including a plurality of inverters connected in a ring shape; and
   a drive circuit configured to drive the ring oscillator, wherein
   the drive circuit is configured to suppress a change in oscillation frequency of the ring oscillator due to a temperature change.

2. The circuit device according to claim 1, wherein the drive circuit includes a negative feedback control unit configured to perform negative feedback control of a power supply current on a basis of a power supply voltage of the ring oscillator, the power supply voltage being generated when at least a part of the power supply current is supplied to the ring oscillator.

3. The circuit device according to claim 2, wherein

   substantially all of the power supply current is supplied to the ring oscillator, and
   a ratio between the power supply voltage and the power supply current is substantially constant.

4. The circuit device according to claim 3, wherein

the negative feedback control unit includes a reference resistor configured to define the ratio, and
a temperature coefficient of a resistance value of the reference resistor is set to a predetermined value or less.

5. The circuit device according to claim 3, wherein

the ring oscillator includes a load capacitor connected to the inverter, and
a temperature coefficient of a capacitance value of the load capacitor is set to a predetermined value or less.

6. The circuit device according to claim 3, wherein

the negative feedback control unit includes a reference resistor configured to define the ratio, and
a resistance value of the reference resistor is set according to a target set value of the oscillation frequency.

7. The circuit device according to claim 6, wherein the resistance value is set lower as the target set value is higher.

8. The circuit device according to claim 2, wherein
the drive circuit includes:

a voltage follower; and
a buffer circuit,
substantially all of the power supply current is supplied to the ring oscillator, and the power supply voltage is supplied to the voltage follower, and
the power supply voltage reproduced by the voltage follower serves as a power supply of the buffer circuit.

9. The circuit device according to claim 8, wherein the drive circuit includes a level shifter configured to convert an output signal of the buffer circuit into a toggle signal that reciprocates between a reference potential and a power supply potential.

10. The circuit device according to claim 2, wherein the drive circuit includes a startup circuit for avoidance of a zero point of the negative feedback control.

11. The circuit device according to claim 2, wherein the drive circuit includes a masking circuit configured to mask an output signal of the ring oscillator immediately after activation.

12. The circuit device according to claim 2, wherein the negative feedback control unit performs negative feedback control on the at least a part of the power supply current to be proportional to a voltage having a negative temperature characteristic.

13. The circuit device according to claim 12, wherein
the negative feedback control unit includes:

a current source for adjustment of a temperature coefficient of the voltage; and
a resistor having a negative temperature characteristic and connected to the current source, and
the negative feedback control unit generates the voltage by using the current source and the resistor.

14. The circuit device according to claim 12, wherein the negative feedback control unit includes a reference resistor configured to define a ratio between the voltage and the power supply current and having a variable resistance value.

15. The circuit device according to claim 12, wherein the drive circuit includes a masking circuit configured to mask an output signal of the ring oscillator immediately after activation.

16. A semiconductor integrated circuit comprising a circuit device, wherein

the circuit device can serve as a clock oscillation source,
the circuit device including:

a ring oscillator including a plurality of inverters connected in a ring shape; and
a drive circuit configured to drive the ring oscillator, and

the drive circuit is configured to suppress a change in oscillation frequency of the ring oscillator due to a temperature change.

17. The semiconductor integrated circuit according to claim 16, further comprising:

a crystal oscillator that can serve as a clock oscillation source, wherein
the oscillation source can be switched between the circuit device and the crystal oscillator.

18. A camera comprising:

a circuit device; and
a solid-state imaging device in which the circuit device serves as a clock oscillation source,
the circuit device including:

a ring oscillator including a plurality of inverters connected in a ring shape; and
a drive circuit configured to drive the ring oscillator, wherein
the drive circuit is configured to suppress a change in oscillation frequency of the ring oscillator due to a temperature change.

19. The camera according to claim 18, wherein a clock from the circuit device is output to an external device via a serial transmission path.

20. A mobile object device comprising:

a camera; and
a mobile object on which the camera is mounted,
the camera including:

a circuit device; and
a solid-state imaging device in which the circuit device serves as a clock oscillation source,
the circuit device including:

a ring oscillator including a plurality of inverters connected in a ring shape; and
a drive circuit configured to drive the ring oscillator, wherein
the drive circuit is configured to suppress a change in oscillation frequency of the ring oscillator due to a temperature change.

# FIG. 1

# FIG. 2

A

LOAD CHARGING

VTOP

Ip

L⇨H

L

C

VSS

B

LOAD DISCHARGING

VTOP

H⇨L

H

In

C

VSS

# FIG. 3

# FIG. 4

# FIG. 5

# FIG. 6

A

VTOP

INV INV INV INV INV

B

INV INV INV

VTOP

CTRL

SC SC SC

# FIG. 7

100-2

50

3

INV1 INV2 INV3

VDD

R_REF

V_REF

ISUP ISUP

VSS

VBOT

C_PASS

5

1 2

# FIG. 8

100-3

# FIG. 9

# FIG. 10

A

B

# FIG. 11

# FIG. 12

A

B

# FIG. 13

8

81

82

VTOP

VTOP2

83

84

# FIG. 14

A

B

# FIG. 15

*FIG. 16*

# FIG. 17

# FIG. 18

## FIG. 19

200-1

TEMPERATURE COEFFICIENT ADJUSTMENT CURRENT SOURCE

$I_{DIODE}$

$V_{DIODE}$

NEGATIVE TEMPERATURE CHARACTERISTIC RESISTANCE LOAD

VDD

ISUP

ISUP

$V_{REF}$

$C_{PASS}$

REFERENCE RESISTOR $R_{REF}$

VSS

VTOP

INVERTER RING

BUFFER

LEVEL SHIFTER

MASKING CIRCUIT

OSC_OUT

EP 4 779 869 A1

# FIG. 20

A

OPERATING POINT OF INVERTER RING
OSCILLATING AT SAME FREQUENCY

HIGH
TEMPERATURE

NORMAL
TEMPERATURE

LOW
TEMPERATURE

VTOP

$VTOP \propto ISPR$

CURRENT-VOLTAGE CHARACTERISTIC
OF INVERTER RING

ISUP

ISUPB  ISUPR

B

ISUP TO INVERTER RING
AND BUFFER FOR OSCILLATING
AT SAME FREQUENCY

TEMPERATURE

LOW TEMPERATURE

NORMAL TEMPERATURE

HIGH TEMPERATURE

# FIG. 21

FIG. 22

# FIG. 23

# FIG. 24

132 → CURRENT MIRROR MASTER *MOS*

CASCODE BIAS

134

131

CTRIM<3:0>

TEMPERATURE COEFFICIENT TRIM HOUSE

137

13

133 CURRENT MIRROR SLAVE *MOS*

135 CASCODE *MOS*

136 SWITCH *MOS*

138

$I_{DIODE}$

# FIG. 25

A

B

C

D

# FIG. 26

## FIG. 27

EP 4 779 869 A1

# FIG. 28

EP 4 779 869 A1

# FIG. 29

EP 4 779 869 A1

# FIG. 30

500

184  185  182  186  183  181

# FIG. 31

200-M1

13

3

1

2

VDD

TEMPERATURE
COEFFICIENT ADJUSTMENT
CURRENT SOURCE

$I_{DIODE}$

ISUP

ISUP

INVERTER RING

VTOP

$V_{DIODE}$

$V_{REF}$

$C_{PASS}$

NEGATIVE TEMPERATURE
CHARACTERISTIC
RESISTANCE LOAD

REFERENCE
RESISTOR

$R_{REF}$

VSS

14

4

5

# FIG. 32

200-M2

TEMPERATURE
COEFFICIENT ADJUSTMENT
CURRENT SOURCE

$I_{DIODE}$

$V_{DIODE}$

VDD

ISUP    ISUP

$V_{REF}$

NEGATIVE TEMPERATURE
CHARACTERISTIC
RESISTANCE LOAD

REFERENCE
RESISTOR    $R_{REF}$

VSS

INVERTER RING    VTOP

$C_{PASS}$

# FIG. 33

200-M3

TEMPERATURE
COEFFICIENT ADJUSTMENT
CURRENT SOURCE

$I_{DIODE}$

$V_{DIODE}$

NEGATIVE TEMPERATURE
CHARACTERISTIC
RESISTANCE LOAD

VDD

$ISUP$   $ISUP$

$V_{REF}$

VTOP

$C_{PASS}$

REFERENCE
RESISTOR

$R_{REF}$

VSS

INVERTER RING    BUFFER

13   3   1   11   2   12

14   4   5   7

## INTERNATIONAL SEARCH REPORT

International application No.

**PCT/JP2024/028309**

**A. CLASSIFICATION OF SUBJECT MATTER**

*H03K 3/354*(2006.01)i; *H03K 19/003*(2006.01)i
FI: H03K3/354 C; H03K3/354 B; H03K19/003 169

According to International Patent Classification (IPC) or to both national classification and IPC

**B. FIELDS SEARCHED**

Minimum documentation searched (classification system followed by classification symbols)

H03K3/354; H03K19/003

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | CN 107241083 A (SHANGHAI AISINOCHIP ELECTRONIC TECH CO., LTD.) 10 October 2017 (2017-10-10) paragraphs [0001]-[0073], fig. 1-3 | 1-7, 10, 16 |
| Y | | 10-11, 17-20 |
| A | | 8-9, 12-15 |
| X | WO 2023/059440 A1 (QUALCOMM INCORPORATED) 13 April 2023 (2023-04-13) paragraphs [0001]-[0113], fig. 1-12 | 1-7, 16 |
| Y | | 10-11, 17-20 |
| A | | 8-9, 12-15 |
| X | JP 2016-025644 A (KABUSHIKI KAISHA TOSHIBA) 08 February 2016 (2016-02-08) paragraphs [0001]-[0078], fig. 1-8 | 1-7, 16 |
| Y | | 10-11, 17-20 |
| A | | 8-9, 12-15 |

☑ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **18 October 2024** | **29 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT

| International application No. |
| --- |
| **PCT/JP2024/028309** |

### C.    DOCUMENTS CONSIDERED TO BE RELEVANT

| Category* | Citation of document, with indication, where appropriate, of the relevant passages | Relevant to claim No. |
| --- | --- | --- |
| Y | US 2020/0153417 A1 (NXP B.V.) 14 May 2020 (2020-05-14)<br>  paragraphs [0001]-[0066], fig. 1-4 | 11 |
| A |  | 15 |
| Y | US 5550489 A (QUANTUM CORPORATION) 27 August 1996 (1996-08-27)<br>  column 1, line 1 to column 11, line 54, fig. 1-6 | 17 |
| Y | JP 2018-189413 A (SEIKO EPSON CORPORATION) 29 November 2018 (2018-11-29)<br>  paragraphs [0001]-[0237], fig. 1-12 | 18-20 |
| A | JP 2002-033644 A (SAMSUNG ELECTRONICS CO., LTD.) 31 January 2002 (2002-01-31)<br>  entire text, all drawings | 1-20 |
| A | JP 2005-533443 A (KONINKLIJKE PHILIPS ELECTRONICS N.V.) 04 November 2005<br>(2005-11-04)<br>  entire text, all drawings | 12-15 |

Form PCT/ISA/210 (second sheet) (July 2022)

## INTERNATIONAL SEARCH REPORT
### Information on patent family members

| International application No. |
| --- |
| **PCT/JP2024/028309** |

| Patent document<br>cited in search report | | | Publication date<br>(day/month/year) | Patent family member(s) | | | Publication date<br>(day/month/year) |
| --- | --- | --- | --- | --- | --- | --- | --- |
| CN | 107241083 | A | 10 October 2017 | (Family: none) | | | |
| WO | 2023/059440 | A1 | 13 April 2023 | US | 2023/0105664 | A1 | |
| | | | | CN | 117980852 | A | |
| | | | | KR | 10-2024-0049389 | A | |
| JP | 2016-025644 | A | 08 February 2016 | US 2016/0028406 A1<br>paragraphs [0002]-[0082], fig.<br>1-8 | | | |
| US | 2020/0153417 | A1 | 14 May 2020 | (Family: none) | | | |
| US | 5550489 | A | 27 August 1996 | (Family: none) | | | |
| JP | 2018-189413 | A | 29 November 2018 | US 2018/0313864 A1<br>paragraphs [0001]-[0248], fig.<br>1-12 | | | |
| JP | 2002-033644 | A | 31 January 2002 | US 2002/0000889 A1<br>entire text, all drawings<br>KR 10-2001-0106856 A | | | |
| JP | 2005-533443 | A | 04 November 2005 | US 2004/0012449 A1<br>entire text, all drawings<br>WO 2004/008639 A2<br>CN 1669221 A | | | |

Form PCT/ISA/210 (patent family annex) (July 2022)

**REFERENCES CITED IN THE DESCRIPTION**

**Patent documents cited in the description**

- JP H03252216 A
- JP 2004080550 A
- JP 2001068976 A